# EUROPEAN PATENT SPECIFICATION

(11) **EP 3 508 550 B1**
(45) Date of publication and mention of the grant of the patent: **14.10.2026**
(21) Application number: 17846509.2
(22) Date of filing: 29.08.2017
(51) Int. Cl.: C09K 3/14, C09G 1/02, B24B 37/00, H10P 90/00

(54) **POLISHING COMPOSITION AND POLISHING COMPOSITION SET**
POLIERZUSAMMENSETZUNG UND POLIERZUSAMMENSETZUNGSSET
COMPOSITION DE POLISSAGE ET ENSEMBLE DE COMPOSITION DE POLISSAGE

(30) Priority: 31.08.2016 JP 2016170184
(43) Date of publication of application: 10.07.2019
(73) Proprietor: Fujimi Incorporated, Kiyosu-shi, Aichi 452-8502 (JP)
(72) Inventor: TSUCHIYA, Kohsuke, Kiyosu-shi Aichi 452-8502 (JP); TANSHO, Hisanori, Kiyosu-shi Aichi 452-8502 (JP); ICHITSUBO, Taiki, Kiyosu-shi Aichi 452-8502 (JP); ASADA, Maki, Kiyosu-shi Aichi 452-8502 (JP)
(74) Representative: Grünecker Patent- und Rechtsanwälte PartG mbB
(86) International application number: PCT/JP2017/031008
(87) International publication number: WO 2018/043504

(56) References cited:
- EP-A1- 3 406 684
- WO-A1-2013/137212
- WO-A1-2014/030570
- WO-A1-2014/148399
- WO-A1-2015/060293
- JP-A- 2006 186 356
- JP-A- 2009 147 267
- JP-A- 2014 038 906
- JP-A- 2014 116 557
- JP-A- 2015 109 423
- JP-A- 2016 056 220
- US-A1- 2015 079 789

## Description

### Technical Field

The present invention relates to a polishing composition and a polishing composition set.

### Background Art

Polishing using a polishing composition including an abrasive is performed on the surface of a material such as a metal, a metalloid, a nonmetal, an oxide thereof, or the like. For example, the surface of a silicon substrate used for manufacturing a semiconductor product or the like is generally finished into a high-quality mirror surface through a lapping step and a polishing step. The polishing step typically includes a stock polishing step and a final polishing step. Patent Literature 1 to 3 are cited as technical literature on polishing compositions mainly used for polishing semiconductor substrates such as silicon wafers. Patent Literature 4 discloses a polishing composition containing a water-soluble polymer satisfying the following two conditions (A) and (B): Condition (A): in a first standard solution which contains silica having an average primary particle size of 35 nm, the water-soluble polymer, ammonia, and water and in which the concentration of the silica is 0.48% by mass, the concentration of the water-soluble polymer is 0.0125% by mass, and the pH is 10.0, the adsorption ratio which is a ratio of the amount of the water-soluble polymer adsorbed to the silica to the total amount of the water-soluble polymer contained in the first standard solution is 10% or more; and Condition (B): in a second standard solution which contains silica having an average primary particle size of 35 nm, the water-soluble polymer, ammonia, and water and in which the concentration of the silica is 0.48% by mass, the concentration of the water-soluble polymer is 0.0125% by mass, and the pH is 10.4, the adsorption ratio which is a ratio of the amount of the water-soluble polymer adsorbed to the silica to the total amount of the water-soluble polymer contained in the second standard solution is 65% or less. Patent Literature 5 discloses a polishing liquid composition for silicon wafers containing 0.01-0.5% by mass of silica particles, a nitrogen-containing basic compound and a water-soluble polymer. The water-soluble polymer is preferably composed of at least one substance that is selected from the group consisting of a polyglycidol, a polyglycidol derivative, a polyglycerol, a polyglycerol derivative, and a polyvinyl alcohol-polyethylene glycol graft copolymer that has a polyvinyl alcohol as a side chain. Patent Literature 6 discloses a polishing composition having a pH of 7 or more and being used in applications for polishing a silicon substrate. The polishing composition contains abrasive grains and a water-soluble polymer. The water-soluble polymer is a copolymer including a first monomer unit having a characteristic value P of 50-100 inclusive, and a second monomer unit having a characteristic value P of at least -100 and less than 50. The characteristic value P is the result of subtracting an adsorption coefficient S2 of the abrasive grains obtained through a specific standard test B from a wettability coefficient S1 of the silicon substrate obtained through a specific standard test A.

### Citation List

### Patent Literature

Patent Literature 1: WO 2014/148399
Patent Literature 2: Japanese Patent Application Publication No. 2015-109423
Patent Literature 3: Japanese Patent Application Publication No. 2016-56220
Patent Literature 4: EP 3406684 A1
Patent Literature 5: WO 2015/060293 A1
Patent Literature 6: US 2015/079789 A1

### Summary of Invention

### Technical Problem

The polishing composition used in the final polishing step is required to be capable of realizing a surface with low haze and few surface defects after polishing. The final polishing step may be, for example, a final polishing step of a semiconductor substrate such as a silicon wafer or other substrate. In addition to abrasive and water, polishing compositions for such applications often include water-soluble polymers for the purpose of protecting the surface of the polishing object, improving wettability and the like. Among them, a general-purpose water-soluble polymer is exemplified by hydroxyethyl cellulose (HEC).

However, since HEC is derived from cellulose, which is a natural product, controllability of chemical structure and purity is limited as compared with synthetic polymers. For example, the range of weight average molecular weight (Mw) and molecular weight distribution of HEC that is readily available in the market is limited. Here, the molecular weight distribution refers to the ratio of Mw to a number average molecular weight (Mn). In addition, since HEC uses a natural product as a raw material, it is difficult to reduce significantly the amount of contaminants, which can cause surface defects, and micro-aggregation due to local disturbance of polymer structure, and the amount of such contaminants and the degree of micro-aggregation are likely to vary. As the demand for surface quality after polishing is expected to grow steadily in the future, it would be beneficial to provide a polishing composition that does not contain HEC as an essential component and is capable of effectively reducing surface defects.

In view of such circumstances, it is an object of the present invention to provide a polishing composition effective for reducing surface defects. Another related invention provides a polishing composition set including such a polishing composition.

### Solution to Problem

LPD (Light Point Defects) and LPD-N (Light Point Defect Non-cleanable) are known as one of the defects observed on a polished surface after polishing with a polishing composition. LPD means contaminants generally called particles. Meanwhile, LPD-N means a defect that cannot be eliminated by processing such as polishing, cleaning, drying and the like, and mainly refers to a surface defect based on the structure of the polishing object itself. As a result of intensive studies, the inventors of the present invention have found a polishing composition effective for reducing the number of LPD-N, and this finding led to the completion of the present invention.
The subject matter of the invention is as set out in the appended claims.

The polishing composition provided by the present invention includes an abrasive, a water-soluble polymer, a basic compound, and a surfactant having a weight-average molecular weight of less than 1 × 10⁴. The water-soluble polymer includes a polymer A that satisfies both of the following conditions (1) and (2).
(1) Includes a vinyl alcohol unit and a non-vinyl alcohol unit in one molecule.
(2) An adsorption parameter calculated by the following formula is 5 or more:$Adsorption parameter = \left[\left(C1-C2\right)/C1\right] \times 100 .$
Here, C1 in the above formula is the total amount of organic carbon contained in a test liquid L1 including 0.017% by weight of the polymer A and 0.009% by weight of ammonia, the remainder being water. C2 in the above formula is the total amount of organic carbon contained in a supernatant liquid obtained by centrifugally separating a test liquid L2 including 0.46% by weight of colloidal silica having a BET diameter of 35 nm, 0.009% by weight of ammonia, and 0.017% by weight of the above polymer A, the remainder being water, and precipitating the silica particles. The polymer A is a random copolymer including a vinyl alcohol unit and an N-vinyl pyrrolidone unit in one molecule wherein the molar ratio of the vinyl alcohol units to the N-vinyl pyrrolidone units is 70:30 or greater or a copolymer including a vinyl alcohol unit and an oxyalkylene unit in one molecule. The polishing composition further comprises a surfactant having a weight-average molecular weight of less than 1 × 10⁴, the amount of the surfactant is 0.001 parts by weight or more and 20 parts by weight or less per 100 parts by weight of the abrasive, and the surfactant is a nonionic surfactant selected from the group consisting of block copolymers of ethylene oxide and propylene oxide, random copolymers of ethylene oxide and propylene oxide, and polyoxyethylene alkyl ethers, or an anionic surfactant comprising a polyoxyalkylene structure.

With such a polishing composition, surface defects on the surface after polishing can be effectively reduced. The polishing composition is effective, for example, for reducing the number of defects detected as LPD-N on the polished surface.

Also provided a polishing composition set including a final polishing composition including any of the polishing compositions disclosed herein and a stock polishing composition to be used for polishing performed before the polishing with the final polishing composition. The stock polishing composition includes an abrasive, a water-soluble polymer and a basic compound. By performing the stock polishing step and the final polishing step in this order by using such a polishing composition set, the surface quality after the final polishing can be effectively improved.

### Description of Embodiments

Preferred embodiments of the present invention will be described below. Incidentally, matters other than matters particularly mentioned in the present specification and necessary for the implementation of the present invention can be grasped as design matters of those skilled in the art based on the prior art in the relevant field. The present invention can be carried out based on the contents disclosed in this specification and technical common sense in the field.

### <Abrasive >

The material and properties of the abrasive included in the polishing composition disclosed herein are not particularly limited and can be appropriately selected according to the purpose of use and mode of use of the polishing composition. Examples of abrasive include inorganic particles, organic particles, and organic-inorganic composite particles. Specific examples of the inorganic particles include oxide particles such as silica particles, alumina particles, cerium oxide particles, chromium oxide particles, titanium dioxide particles, zirconium oxide particles, magnesium oxide particles, manganese dioxide particles, zinc oxide particles, and red iron oxide particles; nitride particles such as silicon nitride particles, and boron nitride particles; carbide particles such as silicon carbide particles, and boron carbide particles; diamond particles; and carbonates such as calcium carbonate, and barium carbonate. Specific examples of the organic particles include polymethyl methacrylate (PMMA) particles, poly(meth)acrylic acid particles, and polyacrylonitrile particles. Such abrasive may be used singly or in combination of two or more types thereof. In the present specification, (meth)acrylic means to be inclusive of acrylic and methacrylic. Likewise, (meth)acryloyl as used herein means to be inclusive of acryloyl and methacryloyl.

As the above abrasive, inorganic particles are preferable, and among them, particles composed of oxides of metals or metalloid are preferable, and silica particles are particularly preferable. In polishing compositions that can be used for polishing, for example, for final polishing, of polishing objects having a surface made of silicon, such as silicon wafers described below, it is particularly significant to use silica particles as abrasive. The art disclosed herein can be preferably implemented, for example, in an embodiment in which the abrasive is substantially composed of silica particles. Here, "substantially" means that 95% by weight or more, preferably 98% by weight or more, more preferably 99% by weight or more of the particles constituting the abrasive is silica particles, and it includes that 100% by weight of the particles are silica particles.

Specific examples of silica particles include colloidal silica, fumed silica, and precipitated silica. The silica particles may be used singly or in combination of two or more types thereof. The use of colloidal silica is particularly preferable, since a polished surface excellent in surface quality can be easily obtained after polishing. For example, colloidal silica prepared by an ion exchange method using water glass (sodium silicate) as a raw material and alkoxide method colloidal silica can be preferably used. Alkoxide method colloidal silica refers to colloidal silica produced by a hydrolytic condensation reaction of an alkoxysilane. Colloidal silica may be used singly or in combination of two or more types thereof.

The true specific gravity of the abrasive constituting material is preferably 1.5 or more, and more preferably 1.6 or more. Here, the true specific gravity of the abrasive grain constituting material means, for example, the true specific gravity of silica constituting the silica particles in the case of abrasive composed of silica particles. Hereinafter, it is also called true specific gravity of the abrasive. As a result of increasing the true specific gravity of the abrasive, the physical abrasive ability of the abrasive grains tends to increase. As the physical abrasive ability of the abrasive grains increases, the local stress created by the abrasive in the surface of the polishing object generally tends to become large. Accordingly, due to an increase in the true specific gravity (true density) of the abrasive, the effect of including the polymer A disclosed herein in the polishing composition can be more effectively exhibited. From this viewpoint, the abrasive having a true specific gravity of 1.7 or more are particularly preferable. The upper limit of the true specific gravity of the abrasive is not particularly limited, but is typically 2.3 or less, for example, 2.2 or less. A measured value obtained by a liquid displacement method using ethanol as a displacement liquid can be used as the true specific gravity of the abrasive. The abrasive may be, for example, silica particles.

The BET diameter of the abrasive is not particularly limited, but from the viewpoint of polishing removal rate, the BET diameter is preferably 5 nm or more and more preferably 10 nm or more. From the viewpoint of obtaining a higher polishing effect, for example, from the viewpoint of better exhibiting the effect of reducing haze, and removing defects, the BET diameter is preferably, for example, 15 nm or more, more preferably 20 nm or more, and still more preferably more than 20 nm. Also, from the viewpoint of suppressing the local stress created by the abrasive in the surface of the polishing object, the BET diameter of the abrasive is preferably 100 nm or less, more preferably 50 nm or less, and even more preferably 40 nm or less. From the viewpoint of making it easier to obtain a higher quality surface, for example, a surface having a small number of LPD-N and a low haze level, the art disclosed herein may be implemented in an embodiement of using abrasive having a BET diameter of 35 nm or less, preferably less than 35 nm, more preferably 32 nm or less, for example, less than 30 nm. The abrasive can be, for example, silica particles.

In the present specification, the BET diameter refers to the particle diameter calculated by a formula of BET diameter [nm] = 6000/(true density [g/cm³] × BET value [m²/g]) from the specific surface area (BET value) measured by the BET method. For example, in the case of silica particles, the BET diameter can be calculated from BET diameter [nm] = 2727/BET value [m²/g]. The specific surface area can be measured, for example, by using a surface area measuring apparatus "Flow Sorb II 2300" manufactured by Micromeritics Instrument Corporation.

The shape (outer shape) of the abrasive may be globular or non-globular. Specific examples of non-globular particles include particles of a peanut shape, a cocoon shape, a konpeito shape, and a rugby ball shape. The above-mentioned peanut shape is the shape of the peanut shell. For example, abrasive in which most of the particles have a peanut shape can preferably be used.

Although not particularly limited, the average aspect ratio of the abrasive, that is, the average value of the major axis/minor axis ratio of the abrasive is in principle 1.0 or more, preferably 1.05 or more, and even more preferably 1.1 or more. By increasing the average aspect ratio, it is possible to achieve higher polishing removal rate. From the viewpoint of reducing scratching, the average aspect ratio of the abrasive is preferably 3.0 or less, more preferably 2.0 or less, and even more preferably 1.5 or less.

The shape (outer shape) and the average aspect ratio of the abrasive can be grasped by, for example, observation with an electron microscope. A specific procedure for grasping the average aspect ratio includes, for example, drawing a minimum rectangle circumscribing each particle image for predetermined number of silica particles for which the shape of an independent particle can be recognized by using a scanning electron microscope (SEM). The predetermined number is, for example, 200 particles. Then, with respect to the rectangle drawn for each particle image, the length of the longer side is taken as a value of a major axis, the length of the shorter side is taken as a value of a minor axis, and a value obtained by dividing the value of the major axis by the value of the minor axis, that is, the major axis/minor axis ratio, is calculated as the aspect ratio. By arithmetically averaging the aspect ratios of the predetermined number of particles, the average aspect ratio can be obtained.

### <Water-soluble Polymer>

The polishing composition disclosed herein includes a water-soluble polymer. As the water-soluble polymer, polymers having at least one functional group selected from a cationic group, an anionic group and a nonionic group in its molecule may be used singly or in combination of two or more thereof. More specifically, for example, one or two or more polymers selected from polymers having a hydroxyl group, a carboxy group, an acyloxy group, a sulfo group, a primary amide structure, a heterocyclic structure, a vinyl structure, and a polyoxyalkylene structure in the molecule can be used as the water-soluble polymer. From the viewpoints of reducing the number of aggregates and improving cleanability, in one embodiment, a nonionic polymer can be preferably used as the water-soluble polymer.

### (Polymer A)

The polishing composition in the art disclosed herein includes a polymer A that satisfies both of the above conditions (1) and (2) as a water-soluble polymer. The polymer A is a random copolymer including a vinyl alcohol unit and an N-vinyl pyrrolidone unit in one molecule wherein the molar ratio of the vinyl alcohol units to the N-vinyl pyrrolidone units is 70:30 or greater or a copolymer including a vinyl alcohol unit and an oxyalkylene unit in one molecule.

### [Condition (1)]

The condition (1), which is to be satisfied by the polymer A, is that the polymer includes a vinyl alcohol unit and a non-vinyl alcohol unit in one molecule. That is, a part of the polymer A of one molecule is constituted by a vinyl alcohol unit, and the other part is constituted by a non-vinyl alcohol unit. Here, the vinyl alcohol unit (hereinafter also referred to as "VA unit") refers to a structural moiety represented by the following chemical formula: - CH₂-CH(OH)-. The VA unit can be produced, for example, by hydrolysis (also referred to as saponification) of a repeating unit of a structure obtained by vinyl polymerization of a vinyl ester type monomer such as vinyl acetate. Further, the non-vinyl alcohol unit (hereinafter also referred to as "non-VA unit") refers to a repeating structural moiety constituted by a structure different from the VA unit. The polymer A may include only one type of non-VA units, or may include two or more types of non-VA units.

**In** one embodiment of the art disclosed herein, the non-VA units may be included in the polymer A as part of the repeating unit that constitutes the polymer A. The polymer A having such a structure can be grasped as a copolymer including a VA unit and a non-VA unit as repeating units constituting the polymer A. By including the non-VA unit in such a form, the adsorption parameter of polymer A including the VA unit can be adjusted to the preferred range disclosed herein. The non-VA unit included as a repeating unit constituting the polymer A can be, for example, a repeating unit having at least one structure selected from an oxyalkylene group, a carboxy group, a sulfo group, an amino group, a hydroxyl group, an amide group, an imide group, a nitrile group, an ether group, an ester group, or a salt thereof. The ratio of the number of moles of VA units to the number of moles of all the repeating units constituting the polymer A is not particularly limited as long as it can satisfy the condition (2). This ratio may be, for example, 5% or more, and may be 10% or more. From the viewpoint of affinity for the abrasive and the polishing object, for example, a silicon wafer, in one embodiment, the polymer A having the above ratio of 20% or more, for example, 30% or more can be preferably used. **In** some embodiments, the ratio may be 50% or more, 75% or more, and 85% or more. Further, from the viewpoint that the favorable effect of including the VA unit and the non-VA unit in combination be easily exerted, the ratio of the number of moles of VA units to the number of moles of all the repeating units constituting the polymer A may be, for example, 99% or less, 98% or less, and 97% or less. **In** some embodiments, the ratio may be, for example, 95% or less, 90% or less, 80% or less, or even 70% or less.

**In** another embodiment of the art disclosed herein, the non-VA unit can be included in the polymer A in a form located at at least one end of the polymer A including the VA unit. Here, the end of the polymer A is typically the end of the main chain of the polymer A, and when the polymer A has a side chain, the end of the side chain can also be the end of the polymer A. Further, that the non-VA unit is located at the end of the polymer A means that the predetermined range including the end is constituted by the non-VA unit. The polymer A having such a structure can be grasped as a polymer having a structure in which the end of a polymer chain including the VA unit is changed or modified in the non-VA unit. The polymer chain including the VA unit may be a polymer chain substantially consisting of only the VA unit. By including the non-VA units in such a form, the adsorption parameter of the polymer A including the VA unit can be adjusted to the preferred range disclosed herein. The non-VA unit may be located at both ends of the main chain of the polymer A, or may be located only at one end. When the polymer A has side chains, the non-VA unit may be located only at one end or both ends of the main chain, or may be located only at all or some of the ends of the side chains. For example, a polymer A having a structure in which the non-VA unit is located only at one end of the main chain can be preferably employed. The non-VA unit positioned at the end of the polymer A can include, for example, at least one structure selected from the group consisting of a hydrocarbon group such as an alkyl group, an aryl group, and an arylalkyl group; an oxyhydrocarbon group such as an alkoxy group, an aryloxy group, an arylalkyloxy group, and an oxyalkylene group; and a carboxy group, a sulfo group, an amino group, a hydroxyl group, an amide group, an imide group, an imino group, an amidino group, an imidazolino group, a nitrile group, an ether group, an ester group, and salts thereof. The ratio of the weight of the non-VA unit to the weight of the polymer A is not particularly limited as long as it can satisfy the condition (2). The above ratio may be, for example, 25% or less, 10% or less, 5% or less, and 1% or less. A method of introducing the non-VA unit to the end of the polymer is not particularly limited, and a known method can be appropriately used. An example of a method for introducing a non-VA unit includes a method of conducting radical polymerization using a polymerization initiator having a structure including the non-VA unit. For example, by performing radical polymerization using 2,2'-azobis(2-amidinopropane) as a polymerization initiator, an amidino group can be introduced to the end of the polymer. As another example of a method for introducing a non-VA unit is a method using a chain transfer agent having a structure including the non-VA unit. For example, by carrying out the polymerization in the presence of a thiol having an alkyl group such as lauryl mercaptan, the alkyl group can be introduced to the end of the polymer. As yet another example of a method for introducing a non-VA unit, a method using a polymerization terminator having a structure including the non-VA unit can be mentioned.

### [Condition (2)]

The condition (2), which is to be satisfied by the polymer A, is that an adsorption parameter calculated by the following formula is 5 or more: Adsorption parameter = [(C1 - C2)/C1] × 100. Here, C1 in the above formula is the total amount of organic carbon contained in a test liquid L1 including 0.017% by weight of the polymer A and 0.009% by weight of ammonia, the remainder being water. C2 in the above formula is the total amount of organic carbon contained in a supernatant liquid obtained by centrifugally separating a test liquid L2 including 0.46% by weight of colloidal silica having a BET diameter of 35 nm, 0.009% by weight of ammonia, and 0.017% by weight of the above polymer A, the remainder being water, and precipitating the silica particles.

The test liquid L2 includes silica particles in addition to the test liquid L1. When the test liquid L2 is subjected to a centrifugal separation treatment, the water-soluble polymer adsorbed on the silica particles precipitates together with the silica particles and is excluded from the total amount of organic carbon contained in the supernatant. Therefore, it can be said that the larger value of the adsorption parameter means that the ratio of the water-soluble polymer adsorbed to the silica abrasive grain in the total amount of the water-soluble polymer contained in the test liquid L2 is larger.

The centrifugal separation of the test liquid L2 can be performed, for example, by using a centrifugal separator model "Avanti HP-30I", manufactured by Beckman Coulter Inc., under the conditions of 30 min and a rotation speed of 20,000 rpm. The total amount of the organic carbon contained in the test liquid L1 and the total amount of the organic carbon contained in the supernatant liquid after subjecting the test liquid L2 to the centrifugal separation treatment can be obtained by measuring the total organic carbon amount (TOC) of the test liquid L1 and the supernatant. The measurement of TOC can be carried out using, for example, a total organic carbon meter (combustion catalytic oxidation system, model "TOC-5000A") manufactured by Shimadzu Corporation or a similar device.

With the polishing composition including the polymer A satisfying the above conditions (1) and (2), it is possible to effectively reduce the number of surface defects (for example, the number of defects detected as LPD-N) on the polished surface. Without wishing to be bound by theory, for example, the following reason why such an effect is obtained can be considered. Thus, as a result of including the VA unit, the polymer A satisfying the above conditions (1) and (2) exhibits good affinity for a polishing object, for example, a silicon wafer. Meanwhile, in general, the VA unit is unlikely to be adsorbed to abrasive such as silica particles, and the polymer A has adsorptivity at a level satisfying a predetermined adsorption parameter with respect to silica particles. With such a polymer A including the VA unit and having the improved adsorptivity, since the polymer A functions as a buffer material around the abrasive when performing the polishing using the polishing composition including the polymer A, it is possible to reduce the local stress that the abrasive can create on the surface of the polishing object. This is apparently why the occurrence of surface defects caused by the stress is suppressed and the number of LPD-N is effectively reduced.

In one embodiment of the art disclosed herein, a polymer having the adsorption parameter of, for example, 10 or more can be used as the polymer A. The adsorption parameter of the polymer A may be 15 or more, 25 or more, 40 or more, 50 or more, or 60 or more. Due to the increase of the adsorption parameter, the polymer A included in the polishing composition tends to be used more efficiently. Further, in one embodiment, from the viewpoint of availability and ease of synthesis of the polymer A, the adsorption parameter of the polymer A may be, for example, 99 or less, 95 or less, 85 or less, 75 or less, and 70 or less. The art disclosed herein can also be favorably implemented in an embodiment in which a polymer A having an adsorption parameter of 50 or less, 30 or less, or 20 or less is used. The adsorption parameter can be adjusted, for example, by selection of the type of non-VA unit contained in the repeating unit constituting the polymer A and by the molecular structure of the polymer A, the molar ratio between the VA unit and the non-VA unit contained in the polymer A, the arrangement of non-VA unit in the polymer A.

**In** one embodiment of the art disclosed herein, a copolymer including a vinyl alcohol-based segment and a non-vinyl alcohol-based segment in one molecule can be preferably used as the polymer A satisfying the above conditions (1) and (2). Here, in the present specification, the vinyl alcohol-based segment refers to a segment having a VA unit as the main repeating unit. Hereinafter, it is also referred to as "segment S_{A}". Further, in the present specification, the non-vinyl alcohol-based segment refers to a segment having a non-VA unit as the main repeating unit. Hereinafter, it is also referred to as "segment S_{B}". **In the** present specification, the main repeating unit is a repeating unit contained in an amount of more than 50% by weight, unless otherwise specified.

The polymer A having the segment S_{A} and the segment S_{B} in the same molecule exhibits an appropriate affinity for the surface of the polishing object as a result of including the segment S_{A}, so it is suitable for reducing the haze level and improving the wettability. Further, by using the segment S_{B} existing in the same molecule as the segment S_{A}, that is, the segment S_{B} chemically bonded to the segment S_{A}, the affinity of the entire polymer A for the abrasive is adjusted and the polymer A satisfying the condition (2) can be favorably realized. Hereinafter, the polymer A including the segment S_{A} and the segment S_{B} in one molecule may be referred to as "polymer A_{SAB}".

The structure of the polymer A_{SAB} is not particularly limited as long as the polymer includes at least one segment S_{A} and at least one segment S_{B} in the same molecule and the condition (2) is satisfied. The polymer A_{SAB} can be, for example, a block copolymer, a graft copolymer or a random copolymer including a segment S_{A} and a segment S_{B}. The structure of the graft copolymer is not particularly limited, and may be, for example, a graft copolymer having a structure in which a segment S_{B} (side chain) is grafted to a segment S_{A} (main chain), or a graft copolymer having a structure in which a segment S_{A} (side chain) is grafted to a segment S_{B} (main chain). From the viewpoint of facilitating the adjustment of adsorptivity of the polymer A by selection of the segment S_{B}, in one embodiment, a graft copolymer can be preferably used as the polymer A_{SAB}. For example, a polymer A_{SAB} having a structure in which a segment S_{B} is grafted to a segment S_{A} can be used.

### [Segment S_{A}]

The segment S_{A} may include only a VA unit as a repeating unit, and may include a VA unit and a non-VA unit. **In** an embodiment in which the segment S_{A} includes a non-VA unit, the non-VA unit can be, for example, a repeating unit having at least one structure selected from an oxyalkylene group, a carboxy group, a sulfo group, an amino group, a hydroxyl group, an amide group, an imide group, a nitrile group, an ether group, an ester group, and a salt thereof. The segment S_{A} may include only one type of non-VA unit, or may include two or more types of non-VA units.

Favorable examples of a non-VA unit that may be included in the segment S_{A} include an alkyl vinyl ether unit (that is, a repeating unit derived from an alkyl vinyl ether), a monocarboxylic acid vinyl ester unit (that is, a repeating unit derived from a monocarboxylic acid vinyl ester). Non-limiting examples of the alkyl vinyl ether include propyl vinyl ether, butyl vinyl ether, and 2-ethylhexyl vinyl ether. Specific preferred examples of the alkyl vinyl ether unit include a propyl vinyl ether unit, a butyl vinyl ether unit, and a 2-ethylhexyl vinyl ether unit. Non-limiting examples of the monocarboxylic acid vinyl ester include vinyl acetate, vinyl propionate, vinyl butyrate, vinyl isobutyrate, vinyl hexanoate, vinyl caprylate, vinyl laurate, vinyl myristate, vinyl palmitate, vinyl stearate, and vinyl pivalate. Preferred specific examples of the monocarboxylic acid vinyl ester unit include a vinyl acetate unit, a vinyl propionate unit, and a vinyl hexanoate unit.

The ratio of the number of moles of VA units to the number of moles of all the repeating units constituting the segment S_{A} is typically 50% or more, usually suitably 65% or more, and preferably 75% or more, for example, 80% or more. **In** one preferred embodiment, the ratio of the number of moles of VA units to the total number of moles of all the repeating units constituting the segment S_{A} may be, for example, 90% or more, 95% or more, and 98% or more. Substantially 100% of the repeating units constituting the segment S_{A} may be the VA units. "Substantially 100%" as used herein means that a non-VA unit is at least intentionally not included in the segment S_{A}.

### [Segment S_{B}]

The non-VA unit constituting the segment S_{B} can be, for example, a repeating unit having at least one structure selected from an oxyalkylene group, a carboxy group, a sulfo group, an amino group, a hydroxyl group, an amide group, an imide group, a nitrile group, an ether group, an ester group, and salts thereof. The non-VA units constituting the segment S_{B} may be of one type or of two or more types.

**In** one embodiment, the segment S_{B} can be a segment including an oxyalkylene unit as the main repeating unit, that is, an oxyalkylene-based segment. The ratio of the number of moles of the oxyalkylene unit to the number of moles of all the repeating units contained in the oxyalkylene-based segment is not particularly limited and can be set so that the polymer A satisfying the above condition (2) is formed. The above ratio may be, for example, more than 50%, 70% or more, 85% or more, and 95% or more. Substantially all of the repeating units contained in the oxyalkylene-based segment may be oxyalkylene units.

Examples of the oxyalkylene unit include an oxyethylene unit, an oxypropylene unit, and an oxybutylene unit. Each such oxyalkylene unit may be a repeating unit derived from the corresponding alkylene oxide. The oxyalkylene units included in the oxyalkylene-based segment may be of one type or of two or more types. For example, the oxyalkylene-based segment may include a combination of an oxyethylene unit and an oxypropylene unit.

**In** an oxyalkylene-based segment including oxyalkylene units of two or more types, these oxyalkylene units may be random copolymers or block copolymers of corresponding alkylene oxides. The molar ratio of the oxyalkylene units is not particularly limited, and it can be set so as to form a polymer A satisfying the above condition (2). **In** one embodiment, the ratio of the number of moles of oxyethylene units to the number of moles of all the repeating units contained in the oxyalkylene-based segment may be more than 50%, 70% or more, 85% or more, 95% or more, or 100%.

**In** another embodiment, the segment S_{B} can be a segment including an N-vinyl type monomer unit as the main repeating unit, that is, an N-vinyl-based segment. The ratio of the number of moles of the N-vinyl type monomer unit to the total number of moles of all the repeating units contained in the N-vinyl-based segment is not particularly limited, and is set so as to form a polymer A satisfying the above condition (2). The above ratio may be, for example, more than 50%, 70% or more, 85% or more, and 95% or more. Substantially all of the repeating units contained in the N-vinyl-based segment may be N-vinyl type monomer units.

The N-vinyl type monomer unit contained in the N-vinyl-based segment may be a repeating unit derived from an N-vinyl lactam type monomer or an N-vinyl chain amide as described hereinbelow. The segment S_{B} can be, for example, an N-vinyl-based segment having a repeating unit derived from an N-vinyl lactam type monomer such as N-vinyl pyrrolidone (VP) or N-vinyl caprolactam (VC) as the main repeating unit, that is, an N-vinyl lactam-based segment. **In** one embodiment, the ratio of the number of moles of a VP unit to the number of moles of all the repeating units contained in the N-vinyl lactam-based segment may be, for example, more than 50%, 70% or more, 85% or more, 95% or more, or 100%. Here, the VP unit is a repeating unit derived from VP.

### [Random Copolymer Including VA Unit and VP Unit]

In some embodiments, the polymer A satisfying the conditions (1) and (2) may be a random copolymer including a VA unit and a VP unit. Such a random copolymer can be formed by modifying a random copolymer of a monomer capable of being converted into a VA unit and N-vinyl pyrrolidone. For example, by subjecting a random copolymer of vinyl acetate and N-vinyl pyrrolidone to partial saponification or complete saponification, a random copolymer including a VA unit and a VP unit can be obtained. The molar ratio of the VA units to the VP units in such random copolymer is 70 : 30 or more, preferably 75 : 25 or more, and more preferably 80 : 20 or more. In some embodiments, the molar ratio of the VA units to the VP units may be 85 : 15 or more, 90 : 10 or more, and more than 90 : 10. Further, the molar ratio of the VA units to the VP units may be, for example, 99 : 1 or less, 98 : 2 or less, and 97 : 3 or less. In some embodiments, the molar ratio of the VA units to the VP units may be 95 : 5 or less and 93 : 7 or less.

### [Mw and Mn of Polymer A]

The weight average molecular weight (Mw) of the polymer A is not particularly limited. The Mw of the polymer A is usually suitably 1.0 × 10⁴ or more, and may be 1.2 × 10⁴ or more, and 1.5 × 10⁴ or more. As the Mw of the polymer A increases, the wettability of the surface after polishing tends to increase. The Mw of the polymer A is usually suitably 100 x 10⁴ or less, preferably 50 × 10⁴ or less, and may be 30 × 10⁴ or less, for example, 20 × 10⁴ or less. A decrease in the Mw of the polymer A tends to stably exhibit the effect of more uniform adsorption the polymer A on the abrasive and reduction in local stress created on the surface of the polishing object. In one embodiment, the Mw of polymer A may be 15 × 10⁴ or less, 10 × 10⁴ or less, 7 × 10⁴ or less, 5 × 10⁴ or less, 4 × 10⁴ or less, for example, 3 × 10⁴ or less.

When the polymer A is a block copolymer including a segment S_{A} and a segment S_{B} in one molecule, the Mw of each segment constituting the block copolymer, that is, the Mw of each of the segments S_{A} and S_{B} is not particularly limited. In one embodiment, the Mw of each of the above segments may be, for example, 500 or more, usually suitably 1000 or more, 3000 or more, and also may be 5000 or more. The Mw of each segment is usually less than the Mw of the polymer A and is 30 × 10⁴ or less, 10 × 10⁴ or less, 5 × 10⁴ or less, or 2 × 10⁴ or less, and may be 1 × 10⁴ or less.

The relationship between the weight average molecular weight (Mw) and the number average molecular weight (Mn) in the polymer A included in the polishing composition disclosed herein is not particularly limited. From the viewpoint of preventing the generation of aggregates, usually the molecular weight distribution (Mw/Mn) of the polymer A can be preferably 10.0 or less, more preferably 7.0 or less, for example 5.0 or less. In one embodiment, Mw/Mn of the polymer A may be 3.0 or less and 2.0 or less.

### (Polymer B)

In addition to the polymer A, the water-soluble polymer in the polishing composition disclosed herein may include a polymer not corresponding to the polymer A, that is, a polymer that does not satisfy one or both of the above conditions (1) and (2). Hereinafter, a polymer not corresponding to the polymer A is also referred to as "polymer B". By using the polymer B, one or two or more effects such as reduction in the number of LPD-N, reduction in haze level, improvement in wettability, improvement in dispersibility of abrasive can be provided. The polymer B may be used singly or in appropriate combination of two or more types thereof.

A polymer not satisfying one or both of the condition (1) and condition (2), for example, a polymer including an oxyalkylene unit, a polymer including a nitrogen atom, a cellulose derivative, a starch derivative, and a polymer including a vinyl alcohol unit can be appropriately selected for use as the polymer B.

Examples of the polymer including an oxyalkylene unit include polyethylene oxide (PEO), block copolymers of ethylene oxide (EO) and propylene oxide (PO) or butylene oxide (BO), and random copolymers of EO with PO or BO. Among them, block copolymers of EO and PO and random copolymers of EO and PO are preferred. The block copolymer of EO and PO may be a diblock copolymer or a triblock copolymer including a PEO block and a polypropylene oxide (PPO) block. Examples of the triblock copolymer include a PEO-PPO-PEO triblock copolymer and a PPO-PEO-PPO triblock copolymer. Usually, a PEO-PPO-PEO triblock copolymer is more preferable.

The term "copolymer" as used in the present specification means to be inclusive of various copolymers such as a random copolymer, an alternating copolymer, a block copolymer, and a graft copolymer, unless otherwise specified.

Non-limiting examples of the polymer including a nitrogen atom include a polymer including an N-vinyl type monomer unit such as N-vinyl lactam, and N-vinyl chain amide; an imine derivative; and a polymer including an N-(meth)acryloyl monomer unit.

Examples of the polymer including an N-vinyl type monomer unit include polymers including a repeating unit derived from a monomer having a nitrogen-containing heterocycle. The nitrogen-containing heterocycle is exemplified by a lactam ring. Examples of the polymer including such a repeating units include homopolymers and copolymers of N-vinyl lactam type monomers, and homopolymers and copolymers of N-vinyl chain amides. The N-vinyl lactam type monomer copolymer may be, for example, a copolymer having a copolymerization ratio of the N-vinyl lactam type monomer of more than 50% by weight. The copolymer of N-vinyl chain amide may be, for example, a copolymer having a copolymerization ratio of N-vinyl chain amide of more than 50% by weight.

Specific examples of the N-vinyl lactam type monomer include N-vinyl pyrrolidone (VP), N-vinyl piperidone, N-vinyl morpholinone, N-vinyl caprolactam (VC), N-vinyl-1,3-oxazine-2-one, and N-vinyl-3,5-morpholinedione. Specific examples of the polymer including an N-vinyl lactam type monomer unit include polyvinyl pyrrolidone, polyvinyl caprolactam, a random copolymer of VP and VC, a random copolymer of one or both of VP and VC with another vinyl monomer, a block copolymer or a graft copolymer including a polymer chain including one or both of VP and VC. The other vinyl monomer may be, for example, an acrylic monomer, and a vinyl ester monomer. Here, the acrylic monomer refers to a monomer having a (meth)acryloyl group.

Specific examples of the N-vinyl chain amide include N-vinyl acetamide, N-vinyl propionic acid amide, and N-vinyl butyric acid amide.

Examples of the polymer including an N-(meth)acryloyl type monomer unit include a homopolymer and a copolymer of an N-(meth)acryloyl type monomer. Examples of the N-(meth)acryloyl type monomer include a chain amide having an N-(meth)acryloyl group and a cyclic amide having an N-(meth)acryloyl group. The copolymer of the N-(meth)acryloyl type monomer may be, for example, a copolymer having a copolymerization ratio of the N-(meth)acryloyl type monomer of more than 50% by weight.

Examples of the chain amide having an N-(meth)acryloyl group include (meth)acrylamide; an N-alkyl (meth)acrylamide such as N-methyl (meth)acrylamide, N-ethyl (meth)acrylamide, N-propyl (meth)acrylamide, N-isopropyl (meth)acrylamide and N-n-butyl (meth)acrylamide; N,N-dialkyl (meth)acrylamide such as N,N-dimethyl (meth)acrylamide, N,N-diethyl (meth)acrylamide, N,N-dipropyl (meth)acrylamide, N,N-diisopropyl (meth)acrylamide, and N,N-di(n-butyl) (meth)acrylamide. Examples of the polymer including a chain amide having an N-(meth)acryloyl group as a monomer unit include a homopolymer of N-isopropylacrylamide and a copolymer of N-isopropylacrylamide. The copolymer of N-isopropylacrylamide can be, for example, a copolymer having a copolymerization ratio of N-isopropylacrylamide of more than 50% by weight.

Examples of the cyclic amide having an N-(meth)acryloyl group include N-(meth)acryloyl morpholine, and N-(meth)acryloyl pyrrolidine. Examples of the polymer including a cyclic amide having an N-(meth)acryloyl group as a monomer unit include a homopolymer of N-acryloylmorpholine and a copolymer of N-acryloylmorpholine. The copolymer of N-acryloylmorpholine can be, for example, a copolymer having a copolymerization ratio of N-acryloylmorpholine of more than 50% by weight.

The cellulose derivative is a polymer including a β-glucose unit as the main repeating unit. Specific examples of the cellulose derivative include hydroxyethyl cellulose, hydroxypropyl cellulose, hydroxyethyl methyl cellulose, hydroxypropyl methyl cellulose, methyl cellulose, ethyl cellulose, ethyl hydroxyethyl cellulose, and carboxymethyl cellulose. Among them, hydroxyethyl cellulose (HEC) is preferable.

The starch derivative is a polymer including an α-glucose unit as the main repeating unit. Specific examples of the starch derivative include pregelatinized starch, pullulan, carboxymethyl starch, and cyclodextrin. Among them, pullulan is preferable.

Examples of the polymer including a vinyl alcohol unit and corresponding to the polymer B include those including only a VA unit and those including a VA unit and a non-VA unit but not meeting the requirement (2). The polymer including a vinyl alcohol unit and used as the polymer B is typically a polymer that includes a VA unit as the main repeating unit and does not satisfy the condition (2). In the polymer, the ratio of the number of moles of VA units to the total number of moles of all repeating units is, for example, more than 50%, and may be 65% or more, 70% or more, and 75% or more. In the polymer including a vinyl alcohol unit and used as the polymer B, the type of the non-VA unit is not particularly limited and can be, for example, one type or two or more types selected from a propyl vinyl ether unit, a butyl vinyl ether unit, a 2-ethylhexyl vinyl ether unit, a vinyl acetate unit, a vinyl propionate unit, and a vinyl hexanoate unit.

The polymer including a vinyl alcohol unit and used as the polymer B may be a polymer substantially including only VA units. "Substantially" as used herein typically means that 95% or more of all the repeating units are vinyl alcohol units. Incidentally, the polymer including a vinyl alcohol unit which includes substantially only VA units usually has an adsorption parameter of less than 5, for example 3 or less, typically about zero, and therefore does not satisfy the condition (2).

### [Mw and Mn of Polymer B]

In the embodiment in which the water-soluble polymer includes the polymer B, the Mw of the polymer B is not particularly limited. From the viewpoints of filterability and cleanability, for example, a polymer having a Mw of 200 × 10⁴ or less or 150 × 10⁴ or less can be used. The Mw of the polymer B is typically 1 × 10⁴ or more.

The more preferable range of Mw may vary depending on the type of the polymer B.

For example, the Mw of each of the cellulose derivative and the starch derivative as the polymer B is typically less than 200 × 10⁴, preferably 170 × 10⁴ or less, more preferably 150 × 10⁴ or less, and may be 100 × 10⁴ or less, for example, 50 × 10⁴ or less. Typically, the Mw of the polymer B of this type of is 1 × 10⁴ or more, preferably 2 × 10⁴ or more, and may be 3 × 10⁴ or more, 5 × 10⁴ or more, 7 × 10⁴ or more, 15 × 10⁴ or more, and 30 × 10⁴ or more.

Also, for example, the Mw of each of the polymer including an oxyalkylene unit, the polymer including a nitrogen atom, and the polymer including a vinyl alcohol unit is preferably 100 × 10⁴ or less, more preferably 60 × 10⁴ or less, and may be 30 × 10⁴ or less, 20 × 10⁴ or less, for example, 10 × 10⁴ or less. Typically, the Mw of the polymer B of this type is 1 × 10⁴ or more, and may be 1.2 × 10⁴ or more, 1.5 × 10⁴ or more, for example 3 × 10⁴ or more.

Mw/Mn of the polymer B is not particularly limited. From the viewpoints of preventing the generation of aggregates, Mw/Mn is usually preferably 10.0 or less, more preferably 7.0 or less, and even more preferably 5.0 or less.

In this specification, values based on gel permeation chromatography (GPC) of an aqueous system (aqueous system, in terms of polyethylene oxide) can be used as the Mw and Mn of the water-soluble polymer and a surfactant.

### (Amount of Water-soluble Polymer)

Although not particularly limited, the amount of the water-soluble polymer in the polishing composition can be, for example, 0.01 part by weight or more with respect to 100 parts by weight of the abrasive. From the viewpoint of improving the surface smoothness after polishing, the amount of the water-soluble polymer with respect to 100 parts by weight of the abrasive grain is usually suitably 0.1 part by weight or more, and may be 0.5 part by weight or more, 1 part by weight or more, for example, 1.5 parts by weight or more. The amount of the water-soluble polymer with respect to 100 parts by weight of the abrasive may be, for example, 50 parts by weight or less, 30 parts by weight or less, or 20 parts by weight or less. In one embodiment, the amount of the water-soluble polymer with respect to 100 parts by weight of the abrasive may be, for example, 10 parts by weight or less, 7 parts by weight or less, 5 parts by weight or less, 2.5 parts by weight or less, or 2.0 parts by weight or less.

Further, the amount of the polymer A can be, for example, 0.01 part by weight or more with respect to 100 parts by weight of the abrasive contained in the polishing composition. From the viewpoint of more effectively exhibiting the effect of using the polymer A, for example, the reduction of the number of LPD-N, the amount of the polymer A with respect to 100 parts by weight of the abrasive is usually suitably 0.05 parts by weight or more, and may be 0.1 parts by weight or more, 0.5 parts by weight or more, 1 part by weight or more, or 1.5 parts by weight or more. The amount of the polymer A with respect to 100 parts by weight of the abrasive may be, for example, 40 parts by weight or less, 20 parts by weight or less, or 15 parts by weight or less. In one embodiment, the amount of the polymer A with respect to 100 parts by weight of the abrasive may be 10 parts by weight or less, 7 parts by weight or less, or 5 parts by weight or less. The polishing composition disclosed herein is also preferably implemented in an embodiment in which the amount of the polymer A is 2.5 parts by weight or less, for example 2.0 parts by weight or less, with respect to 100 parts by weight of the abrasive. In such a case, the effect of reducing the number of surface defects can be favorably exerted.

In the polishing composition including the polymer A and the polymer B as the water-soluble polymer, the ratio of the polymer A in the entire water-soluble polymer, that is, the ratio of the polymer A to the total weight of the polymer A and the polymer B, can be, for example, 5% or more, and may be 10% or more, on the weight basis. From the viewpoint of obtaining a higher effect, usually, the ratio is suitably at 30% or more, preferably more than 50%, and may be 70% or more, 85% or more, 95% or more, and for example 99% or more.

When a cellulose derivative such as HEC is used as the polymer B, the amount of the cellulose derivative is preferably suppressed to 40% by weight or less, more preferably 25% by weight or less, and even more preferably 10% by weight or less, and even more preferably 5% by weight or less of the whole water-soluble polymer. By restricting the amount of the cellulose derivative, the admixture of foreign matter originating from the cellulose derivative derived from a natural product and the occurrence of aggregation can be suppressed. The polishing composition disclosed herein can be preferably implemented in a form substantially free of cellulose derivatives.

The polishing composition disclosed herein can be preferably implemented in a form such that the amount of the polymer A per 10¹⁷ abrasive grains is 10 mg or more. In addition, the polishing composition disclosed herein can be preferably implemented in a form such that the amount of polymer A per 10¹⁷ abrasive grains is 1000 mg or less. Here, the number of abrasive can be calculated based on the weight of the abrasive contained in the polishing composition, the BET diameter of the abrasive, and the specific gravity of the abrasive. The amount of the polymer A per 10¹⁷ abrasive grains can be calculated from the number of the abrasive and the weight of the polymer A contained in the polishing composition. By including the polymer A, which shows the adsorptivity at a level satisfying the predetermined adsorption parameter with respect to the abrasive grain, in an amount equal to or more than the predetermined weight per the number of the abrasive, a local stress that can be created in the surface of the polishing object by the abrasive can be effectively reduced and the defects reducing effect by the polymer A can be efficiently realized. Further, by selecting the composition of the polishing composition such that the amount of the polymer A per the number of abrasive is equal to or less than the predetermined value, excessive adsorption of the polymer A by the abrasive can be suppressed and the polishing effect of the polishing composition can be exerted efficiently. In one embodiment of the polishing composition disclosed herein, the amount of polymer A per 10¹⁷ abrasive grains may be, for example, 600 mg or less, 400 mg or less, 300 mg or less, or 200 mg or less. From the viewpoint of obtaining a higher polishing effect, in one embodiment, the amount of the polymer A per 10¹⁷ abrasive grains may be 175 mg or less, for example, 150 mg or less, 125 mg or less, or 100 mg or less. In addition, from the viewpoint of favorably exhibiting the defect reducing effect by the polymer A, in one embodiment, the amount of the polymer A per 10¹⁷ abrasive grains can be more than 10 mg, for example, 15 mg or more, 20 mg or more, or 30 mg or more.

The polishing composition disclosed herein can be preferably implemented in such a form that an abrasive grain buffering index calculated from the following formula: abrasive grain buffering index = (W_{A} × Q)/S is 1 mg/m² to 40 mg/m². Here, S in the above formula is the total surface area [m²] of the abrasive contained in the polishing composition. W_{A} in the above formula is the total amount [mg] of the polymer A contained in the polishing composition. Q in the above formula is the adsorption parameter described above. In the polishing composition having a higher abrasive grain buffering index, the adsorption amount of the polymer A per the surface area of the abrasive tends to be larger. Therefore, by selecting the composition of the polishing composition so that the abrasive grain buffering index is not less than the predetermined value, it is possible to efficiently realize the defect reducing effect by the polymer A. In addition, by selecting the composition of the polishing composition so that the abrasive grain buffering index is equal to or less than a predetermined value, it is possible to reduce defects while suppressing excessive reduction in polishing removal rate. Although not particularly limited, in one embodiment, the abrasive grain buffering index may be, for example, 3 mg/m² or more, 5 mg/m² or more, for example, 10 mg/m² or more. In one embodiment, the abrasive grain buffering index may be 30 mg/m² or less, for example, 25 mg/m² or less, 20 mg/m² or less, or 15 mg/m² or less.

### <Water>

Ion exchanged water (deionized water), pure water, ultrapure water, and distilled water can be preferably used as the water contained in the polishing composition disclosed herein. In order to minimize the inhibition of the action of other components contained in the polishing composition by the water used therein, it is preferable that the total amount of transition metal ions be, for example, 100 ppb or less. For example, the purity of water can be increased by operations such as removal of impurity ions with an ion exchange resin, removal of foreign matter with a filter, and distillation.

### <Basic Compound>

The polishing composition disclosed herein includes a basic compound. In the present specification, the basic compound refers to a compound having a function of dissolving in water to raise the pH of the aqueous solution. An organic or inorganic basic compound including nitrogen, a hydroxide of an alkali metal, a hydroxide of an alkaline earth metal, various carbonates, and bicarbonates can be used as the basic compound. Examples of nitrogen-containing basic compounds include quaternary ammonium compounds, quaternary phosphonium compounds, ammonia, and amines. As the amine, a water-soluble amine is preferable. Such basic compounds may be used singly or in combination of two or more types thereof.

Specific examples of the alkali metal hydroxide include potassium hydroxide, and sodium hydroxide. Specific examples of the carbonate and bicarbonate include ammonium hydrogen carbonate, ammonium carbonate, potassium hydrogen carbonate, potassium carbonate, sodium hydrogen carbonate, and sodium carbonate. Specific examples of the amine include methylamine, dimethylamine, trimethylamine, ethylamine, diethylamine, triethylamine, ethylenediamine, monoethanolamine, N-(β-aminoethyl) ethanolamine, hexamethylenediamine, diethylenetriamine, triethylenetetramine, piperazine anhydride, piperazine hexahydrate, 1-(2-aminoethyl) piperazine, N-methylpiperazine, guanidine, and azoles such as imidazole and triazole. Specific examples of the quaternary phosphonium compound include quaternary phosphonium hydroxide such as tetramethylphosphonium hydroxide, and tetraethylphosphonium hydroxide .

A quaternary ammonium salt such as a tetraalkylammonium salt, or a hydroxyalkyltrialkylammonium salt can be preferably used as the quaternary ammonium compound. The anion component in such a quaternary ammonium salt can be, for example, OH⁻, F⁻, Cl⁻, Br⁻, I⁻, ClO₄⁻, BH₄⁻. The quaternary ammonium salt is preferably a strong base. Among them, a quaternary ammonium salt with OH⁻ as an anion, that is, a quaternary ammonium hydroxide can be mentioned as a preferable example. Specific examples of the quaternary ammonium hydroxide include a tetraalkylammonium hydroxide such as tetramethylammonium hydroxide, tetraethylammonium hydroxide, tetrapropylammonium hydroxide, tetrabutylammonium hydroxide, tetrapentylammonium hydroxide, and tetrahexylammonium hydroxide; and a hydroxyalkyltrialkylammonium hydroxide such as 2-hydroxyethyltrimethylammonium hydroxide (also referred to as choline).

Among these basic compounds, for example, at least one basic compound selected from an alkali metal hydroxide, a quaternary ammonium hydroxide and ammonia can be preferably used. Among them, a tetraalkylammonium hydroxide such as tetramethylammonium hydroxide and ammonia are more preferable, and ammonia is particularly preferable.

### <Surfactant as Water-soluble Organic Compound>

A surfactant being a water-soluble organic compound having a weight average molecular weight (Mw) of less than 1 × 10⁴ is contained in the polishing composition disclosed herein. By using such a water-soluble organic compound, the number of LPD-N can be further reduced. The water-soluble organic compounds may be used singly or in combination of two or more types thereof.

### (Surfactant)

In addition to contributing to the reduction of the number of LPD-N, surfactants can also help to reduce the haze level.

As the surfactant, an anionic surfactants or a nonionic surfactant can be used. From the viewpoint of low foaming property and ease of pH adjustment, a nonionic surfactant is more preferable. Suitable examples of the nonionic surfactants include polyoxyethylene alkyl ethers, block copolymers of ethylene oxide and propylene oxide, and random copolymers of ethylene oxide and propylene oxide. The surfactant may be used singly or in combination of two or more types thereof.

Specific examples of the nonionic surfactant include block copolymers of ethylene oxide (EO) and propylene oxide (PO), random copolymers of EO and PO, polyoxyethylene glycol, polyoxyethylene propyl ether, polyoxyethylene butyl ether, polyoxyethylene pentyl ether, polyoxyethylene hexyl ether, polyoxyethylene octyl ether, polyoxyethylene 2-ethylhexyl ether, polyoxyethylene nonyl ether, polyoxyethylene decyl ether, polyoxyethylene isodecyl ether, polyoxyethylene tridecyl ether, polyoxyethylene lauryl ether, polyoxyethylene cetyl ether, polyoxyethylene stearyl ether, polyoxyethylene isostearyl ether, polyoxyethylene oleyl ether, polyoxyethylene phenyl ether, polyoxyethylene octyl phenyl ether, polyoxyethylene nonyl phenyl ether, polyoxyethylene dodecyl phenyl ether, and polyoxyethylene styrenated phenyl ether. Examples of the block copolymer of EO and PO include a diblock copolymer, a PEO (polyethylene oxide) - PPO (polypropylene oxide) - PEO triblock, and a PPO-PEO-PPO triblock copolymer. Among them, surfactants include block copolymers of EO and PO, random copolymers of EO and PO, and polyoxyethylene alkyl ethers. As a favorable example of a block copolymer of EO and PO, a PEO-PPO-PEO triblock copolymer is particularly preferred. A favorable example of the polyoxyethylene alkyl ether is polyoxyethylene decyl ether.

The "anionic surfactant" means a compound having a functional group and a hydrophobic group which are dissociated in water to form an anion and demonstrating a surface active action. Anionic surfactants can be classified into those of sulfuric acid type, sulfonic acid type, phosphoric acid type, phosphonic acid type, and carboxylic acid type. Specific examples of the anionic surfactant include alkyl sulfuric acid esters, polyoxyethylene alkyl sulfuric acid esters, polyoxyethylene alkyl sulfuric acids, alkyl sulfuric acids, alkyl ether sulfuric acid esters, higher alcohol sulfuric acid esters, alkyl phosphoric acid esters, alkylbenzene sulfonic acids, α-olefin sulfonic acids, alkyl sulfonic acids, styrene sulfonic acids, alkyl naphthalene sulfonic acids, alkyl diphenyl ether disulfonic acids, polyoxyethylene alkyl ether acetic acids, polyoxyethylene alkyl ether phosphoric acids, polyoxyethylene alkyl phosphoric acid esters, polyoxyethylene sulfosuccinic acids, alkylsulfosuccinic acids, and salts of any of the above compounds. One specific example of the alkylsulfonic acid is dodecylsulfonic acid. Other examples of the anionic surfactant include taurine surfactants, sarcosinate surfactants, isethionate surfactants, N-acyl acidic amino acid surfactants, higher fatty acid salts, and acylated polypeptides.

In the present invention, an anionic surfactant including a polyoxyalkylene structure is used. The polyoxyalkylene structure refers to a repeating structure in which two or more, preferably three or more, oxyalkylene units are connected. The oxyalkylene unit may be a repeating unit derived from a corresponding alkylene oxide. Therefore, the number of repeating oxyalkylene units can also be grasped as the number of added moles of alkylene oxide.

The oxyalkylene unit is preferably an oxyalkylene group having 2 to 18 carbon atoms. Here, the alkylene group may be substituted with an aryl group. Such an oxyalkylene group can be derived from, for example, ethylene oxide, propylene oxide, 1,2-butylene oxide, 2,3-butylene oxide, and styrene oxide. From the viewpoint of ease of availability, ease of dispersing the surfactant in the polishing composition and ease of reducing the haze of the polished surface, the oxyalkylene unit is preferably an oxyalkylene group having 2 to 10 carbon atoms, and even more preferably an oxyalkylene group having 2 to 4 carbon atoms. Among them, preferred oxyalkylene units are an oxyethylene group and an oxypropylene group. An oxyethylene group is particularly preferred.

The anionic surfactant including a polyoxyalkylene structure is preferably selected from the group consisting of a sulfonic acid ester (R-O-SO₃⁻H⁺) and a salt thereof (R-O-SO₃⁻ M⁺), a sulfonic acid (R-SO₃⁻H⁺) and a salt thereof (R-SO₃⁻M⁺), a carboxylic acid (R-COO⁻H⁺) and a salt thereof (R-COO⁻M⁺), and a phosphoric acid ester (R-O-PO(O⁻H⁺)₂) and a salt (R-O-PO(O⁻H⁺)(O⁻M⁺) or R-O-PO(O⁻M⁺)₂) thereof, but this list is not limiting. In the above description, "R" represents an organic group including a polyoxyalkylene structure. Further, in the above, "M⁺" represents various cations such as a metal cation and an ammonium cation. From the viewpoint of ease of reducing haze, the anionic surfactant is preferably selected from the group consisting of a sulfuric acid ester and a salt thereof, a carboxylic acid and a salt thereof, a phosphoric acid ester and a salt thereof, and a sulfuric acid ester and a salt thereof and carboxylic acid and a salt thereof are more preferred. Here, from the viewpoint that haze can be more effectively reduced, the carboxylic acid and salt thereof is preferably selected from the group consisting of an acetic acid having an organic group including a polyoxyalkylene structure (R'-CH₂COO⁻H⁺) and a salt thereof (R'-CH₂COO⁻M⁺). Here, "R'" represents an organic group including a polyoxyalkylene structure. Therefore, from the viewpoint of further improving the haze reducing effect, it is particularly preferable that the anionic surfactant be selected from the group consisting of a sulfuric acid ester and a salts thereof and the acetic acid and a salt thereof.

In the case of classification by the "M⁺", examples of the salt include salts of alkali metals such as sodium, and potassium, salts of Group 2 elements such as calcium, and magnesium, ammonium salts, alkanolamine salts such as triethanolamine.

In addition, one molecule of the anionic surfactant may include two or more moieties selected from the above-mentioned anion moieties (that is, "-O-SO₃⁻" moiety, " SO₃⁻" moiety, "COO⁻" moiety, "-O-PO(OH)O⁻" moiety, and "-O-PO(O⁻)₂").

In the anionic surfactant including a polyoxyalkylene structure, the average number of added moles of the oxyalkylene unit constituting the polyoxyalkylene structure is preferably more than 3 and not more than 25. With the anionic surfactant in which the average number of added moles of the oxyalkylene unit exceeds 3, the anionic surfactant protects the surface of the polishing object such as a silicon substrate, so that a high haze reducing effect is easily exerted. Where the average number of added moles of the oxyalkylene unit contained in the anionic surfactant exceeds 25, the surface protection of the polishing object such as a silicon substrate by the anionic surfactant becomes excessive and the polishing removal rate can be easily decreased. From the viewpoint of reducing the haze while suppressing the decrease in the polishing removal rate, the average number of added moles of the oxyalkylene unit is preferably 4 or more, and more preferably 4.5 or more. Also from the same viewpoint, the average number of added moles of the oxyalkylene unit is preferably 20 or less, and more preferably 18 or less. It follows from the above that from the viewpoint of achieving both reduction of haze and improvement of polishing removal rate, the average number of added moles of the oxyalkylene unit is preferably 4 or more and 20 or less, and more preferably 4.5 or more and 18 or less. In some embodiments, the average number of added moles of the oxyalkylene unit may be, for example, 6 or more, 10 or more, or 14 or more.

The "average number of added moles" means an average value of the number of moles of alkylene oxide (that is, the number of moles of oxyalkylene units) added in 1 mole of the surfactant. In the case where two or more different oxyalkylene units are contained in the surfactant, an average value thereof needs to be used. Further, the average number of added moles of the alkylene oxide can be appropriately measured by ¹H-NMR, gas chromatography (GC), GPC, gel filtration chromatography (GFC), and titration method.

In some cases, two or more different oxyalkylene units may be present in the anionic surfactant. From the viewpoint of the ease of production of the polyoxyalkylene chain and the ease of control of the structure, it is preferable that the same oxyalkylene unit be repeated.

The sulfuric acid ester and salt thereof which can be used as an anionic surfactant including a polyoxyalkylene structure are not particularly limited, and examples thereof include polyoxyethylene lauryl ether sulfuric acid, polyoxyethylene myristyl ether sulfuric acid, polyoxyethylene palmityl ether sulfuric acid ; sodium polyoxyethylene lauryl ether sulfate, ammonium polyoxyethylene lauryl ether sulfate, triethanolamine polyoxyethylene lauryl ether sulfate, sodium polyoxyethylene myristyl ether sulfate, ammonium polyoxyethylene myristyl ether sulfate, triethanolamine polyoxyethylene myristyl ether sulfate, sodium polyoxyethylene palmityl ether sulfate, polyoxyethylene palmityl ether sulfuric acid amine, and triethanolamine polyoxyethylene palmityl ether sulfate. Of these, sodium polyoxyethylene lauryl ether sulfate and ammonium polyoxyethylene lauryl ether sulfate are preferred.

The sulfonic acid and salt thereof which can be used as an anionic surfactant including a polyoxyalkylene structure are not particularly limited, and examples thereof include polyoxyethylene octyl sulfonic acid, polyoxyethylene lauryl sulfonic acid, polyoxyethylene palmityl sulfonic acid, polyoxyethylene octyl benzene sulfonic acid, polyoxyethylene lauryl benzene sulfonic acid; sodium polyoxyethylene octyl sulfonate, sodium polyoxyethylene lauryl sulfonate, and sodium polyoxyethylene palmityl sulfonate. Of these, polyoxyethylene octyl sulfonic acid and sodium polyoxyethylene octyl sulfonate are preferable.

The carboxylic acid and salt thereof which can be used as an anionic surfactant including a polyoxyalkylene structure are not particularly limited, and examples thereof include an acetic acid including a polyoxyalkylene structure and salts thereof such as polyoxyethylene lauryl ether acetic acid, polyoxyethylene tridecyl ether acetic acid, polyoxyethylene octyl ether acetic acid; sodium polyoxyethylene lauryl ether acetate, ammonium polyoxyethylene lauryl ether acetate, sodium polyoxyethylene tridecyl ether acetate, ammonium polyoxyethylene tridecyl ether acetate, sodium polyoxyethylene octyl ether acetate, and ammonium polyoxyethylene octyl ether acetate. Of these, sodium polyoxyethylene lauryl ether acetate and ammonium polyoxyethylene lauryl ether acetate are preferable.

The phosphoric acid ester and salt thereof which can be used as an anionic surfactant including a polyoxyalkylene structure are not particularly limited, and examples thereof include polyoxyethylene lauryl ether phosphoric acid, polyoxyethylene alkyl (12-15) ether phosphoric acids; sodium polyoxyethylene lauryl ether phosphate, sodium polyoxyethylene oleyl ether phosphate, sodium polyoxyethylene palmityl ether phosphate, and potassium polyoxyethylene alkyl (12-15) ether phosphates. Among them, polyoxyethylene alkyl (12-15) ether phosphoric acids and sodium polyoxyethylene lauryl ether phosphate are preferable.

Examples of the anionic surfactant including two or more of the above anion moieties in one molecule include polyoxyethylene lauryl sulfosuccinic acid disodium salt, and polyoxyethylene lauroyl ethanolamide disodium sulfosuccinate.

**In** such an anionic surfactant, the structure of the end hydrophobic group at the ω position is not particularly limited, and may be substituted, for example, with a substituted or unsubstituted C2 to C30 alkyl group, a substituted or unsubstituted C3 to C20 cycloalkyl group, a substituted or unsubstituted C1 to C30 alkyl ester group, a substituted or unsubstituted C6 to C20 aryl group, a mono- or dialkylamide group having a C1 to C30 alkyl group, or a mono or dialkylamino group having a C1 to C30 alkyl group, or may have a sorbitan structure. Here, "CX to CY" means that the number of carbon atoms is X or more and Y or less.

Examples of the alkyl group include an ethyl group, an n-propyl group, an isopropyl group, an n-butyl group, an isobutyl group, a sec-butyl group, a tert-butyl group, an n-pentyl group, an isopentyl group, a neopentyl group, a 1,2-dimethylpropyl group, an n-hexyl group, an n-heptyl group, an n-octyl group, a 2-ethylhexyl group, an n-decyl group, and an n-dodecyl group.

Examples of the cycloalkyl group include a cyclopentyl group, and a cyclohexyl group.

Examples of the alkyl ester group include a methyl ester group, an ethyl ester group, an n-propyl ester group, an i-propyl ester group, an n-butyl ester group, and a 2-methylpropyl ester group.

Examples of the aryl group include a phenyl group, and an o-, m- or p-tolyl group.

In the present specification, the "substituted or unsubstituted" group means that a hydrogen atom in the group is substituted with a substituent such as a halogen atom such as a fluorine atom, a chlorine atom, and a bromine atom; a cyano group; a nitro group; a hydroxy group; a C1 to C10 linear or branched alkyl group; a C1 to C10 linear or branched alkoxy group; a C6 to C30 aryl group; a C2 to C30 heteroaryl group; and a C5 to C20 cycloalkyl group; or is unsubstituted.

One type of such an anionic surfactant may be used singly, or two or more types thereof may be used in combination.

In some embodiments, a compound in which the polyoxyalkylene structure is a polyoxyethylene structure and the average number of added moles of ethylene oxide in the polyoxyethylene structure is more than 3 and not more than 25 can be preferably used as the anionic surfactant including a polyoxyalkylene structure. From the viewpoint of reducing haze while suppressing reduction in polishing removal rate, the average number of added moles of ethylene oxide is preferably 4 or more, more preferably 4.5 or more. From the same viewpoint, the average number of added moles of ethylene oxide is preferably 20 or less, and more preferably 18 or less. From the above, the average number of added moles of ethylene oxide in the anionic surfactant is preferably 4 or more and 20 or less, more preferably 4.5 or more and 18 or less.

The weight average molecular weight (Mw) of the surfactant is less than 1 × 10⁴, and from the viewpoints of filterability and cleanability, the weight average molecular weight is preferably 9500 or less, for example, less than 9000. From the viewpoint of the surface activation performance, the Mw of the surfactant is usually suitably 200 or more, and from the viewpoint of the effect of lowering the haze level, the Mw of the surfactant is preferably 250 or more, for example, 300 or more. A more preferable range of the Mw of the surfactant may vary depending on the type of the surfactant. For example, when a polyoxyethylene alkyl ether is used as the surfactant, the Mw thereof is preferably 2000 or less, and may be 1000 or less, for example 500 or less. In addition, for example, when a PEO-PPO-PEO triblock copolymer is used as the surfactant, the Mw thereof is, for example, 1000 or more, may be 3000 or more, furthermore 5000 or more. A value (aqueous system, converted to polyethylene glycol) obtained by GPC can be used as the Mw of the surfactant.

When the polishing composition disclosed herein includes a surfactant, the amount thereof is not particularly limited as long as the effect of the present invention is not significantly impaired. From the viewpoint of cleanability, the amount of the surfactant with respect to 100 parts by weight of the abrasive is 20 parts by weight or less, preferably 15 parts by weight or less, more preferably 10 parts by weight or less, for example, 6 parts by weight or less. From the viewpoint of exerting the effect of using the surfactant more satisfactorily, the amount of the surfactant with respect to 100 parts by weight of the abrasive is 0.001 parts by weight or more, preferably 0.005 parts by weight or more, more preferably 0.01 part by weight or more, for example, 0.05 parts by weight or more. In some embodiments, the amount of the surfactant may be, for example, 0.1 parts by weight or more.

Further, in the case where the polishing composition disclosed herein includes a surfactant, the weight ratio (w1/w2) of the amount w1 of the water-soluble polymer and the amount w2 of the surfactant is not particularly limited, and can be, for example, in the range of 0.01 to 100, preferably in the range of 0.05 to 50, and may be in the range of 0.1 to 30.

Alternatively, from the viewpoint of simplification of the composition, the polishing composition disclosed herein can also be preferably implemented in a form including substantially no surfactant.

### <Other Components>

In addition, the polishing composition disclosed herein may optionally include a well-known additive that can be used in a polishing slurry, such as a chelating agent, an organic acid, an organic acid salt, an inorganic acid, an inorganic acid salt, an antiseptic agent, and an antifungal agent, as long as the effects of the present invention are not significantly impaired. For example, known additives that can be used in a polishing slurry which is to be used in polishing of silicon wafers can be used.

It is preferable that the polishing composition disclosed herein be substantially free of an oxidizing agent. This is because when the polishing composition includes an oxidizing agent, as a result of supplying the polishing composition to a polishing object, for example, such as a silicon wafer, the surface of the polishing object is oxidized, an oxide film is formed thereon and the polishing efficiency may be lowered. Specific examples of the oxidizing agent referred to herein include hydrogen peroxide (H₂O₂), sodium persulfate, ammonium persulfate, and sodium dichloroisocyanurate. The polishing composition being substantially free of the oxidizing agent means that an oxidizing agent is not included at least intentionally.

### <pH>

The pH of the polishing composition disclosed herein is typically 8.0 or more, preferably 8.5 or more, more preferably 9.0 or more, even more preferably 9.3 or more, for example, 9.5 or more. When the pH of the polishing composition is increased, the polishing removal rate tends to be improved. Meanwhile, from the viewpoint of suppressing the weakening of the mechanical polishing effect by preventing dissolution of silica particles, the pH of the polishing composition is suitably 12.0 or less, preferably 11.0 or less, more preferably 10.8 or less, and even more preferably 10.5 or less.

In the art disclosed herein, the pH of the liquid composition can be grasped by performing three-point calibration using a standard buffer solution by using a pH meter, placing a glass electrode in the composition to be measured, and measuring a pH value after the composition has been stabilized for 2 min or longer. Examples of standard buffer solutions include a phthalate pH buffer solution, pH: 4.01 (25°C), a neutral phosphate pH buffer solution, pH: 6.86 (25°C), and a carbonate pH buffer solution, pH: 10.01 (25°C). For example, a glass electrode type hydrogen ion concentration indicator manufactured by Horiba Ltd., model number F-23 or equivalent thereof can be used as the pH meter.

### <Use>

The polishing composition according to the art disclosed herein can be used in polishing of polishing objects of various materials and shapes. Examples of materials of the polishing object include metals or metalloids such as silicon, aluminum, nickel, tungsten, copper, tantalum, titanium, and stainless steel or an alloy thereof; a glassy material such as quartz glass, aluminosilicate glass, glassy carbon; ceramic materials such as alumina, silica, sapphire, silicon nitride, tantalum nitride, and titanium carbide; compound semiconductor substrate materials such as silicon carbide, gallium nitride, and gallium arsenide; and resin materials such as polyimide resin. A polishing object composed of a plurality of materials among them may be also polished.

The polishing composition according to the art disclosed herein can be particularly preferably used for polishing a surface made of silicon, such as a silicon wafer. A typical example of the silicon wafer referred to herein is a silicon single crystal wafer, for example, a silicon single crystal wafer obtained by slicing a silicon single crystal ingot.

The polishing composition disclosed herein can be preferably used in a polishing step of a polishing object, for example, a polishing step of a silicon wafer. Prior to the polishing step using the polishing composition disclosed herein, the polishing object may be subjected to a general treatment that can be applied to the polishing object in a step upstream of the polishing step, such as lapping or etching.

The polishing composition disclosed herein can be preferably used, for example, in polishing of a polishing object, for example, a silicon wafer, which has been prepared to have a surface state with a surface roughness of 0.01 nm to 100 nm in an upstream step. The surface roughness Ra of the polishing object can be measured using, for example, a laser scanning type surface roughness meter "TMS-3000WRC" manufactured by Schmitt Measurement Systems Inc. The use of the polishing composition in final polishing (final polishing) or polishing immediately therebefore is effective, and the use thereof in final polishing is particularly preferred. Here, the final polishing refers to the last polishing step in the process of manufacturing the object, that is, a step after which no further polishing is performed.

### <Polishing Composition>

Typically, the polishing composition disclosed herein is supplied to a polishing object in the form of a polishing liquid including the polishing composition, and is used for polishing the polishing object. The polishing liquid may be prepared, for example, by diluting any of the polishing compositions disclosed herein. The dilution of the polishing composition can typically be carried out with water. Alternatively, the polishing composition may be used as it is as a polishing liquid. That is, the concept of a polishing composition in the art disclosed herein is inclusive of a polishing liquid (also referred to as working slurry) that is supplied to a polishing object and used for polishing the polishing object, and a concentrate that is used as a polishing liquid after dilution. The concentrate can also be grasped as a stock solution of a polishing liquid. Another example of the polishing liquid including the polishing composition disclosed herein includes a polishing liquid prepared by adjusting the pH of the composition.

### (Polishing Liquid)

The amount of the abrasive in the polishing liquid is not particularly limited, but is typically 0.01% by weight or more, preferably 0.05% by weight or more, more preferably 0.10% by weight or more, for example, 0.15% by weight or more. A higher polishing removal rate can be achieved by increasing the amount of the abrasive. From the viewpoint of dispersion stability of the particles in the polishing composition, usually, the amount is suitably 10% by weight or less, preferably 7% by weight or less, more preferably 5% by weight or less, even more preferably 2% by weight or less, for example, 1% by weight or less, and may be 0.7% by weight or less.

The concentration of the water-soluble polymer in the polishing liquid is not particularly limited, and can be, for example, 0.0001% by weight or more. From the viewpoint of haze reduction, the preferable concentration is 0.0005% by weight or more, more preferably 0.001% by weight or more, for example, 0.003% by weight or more, and may be 0.005% by weight or more. From the viewpoint of polishing removal rate, usually, the concentration of the water-soluble polymer is preferably 0.2% by weight or less, more preferably 0.1% by weight or less, and may be 0.05% by weight or less, for example, 0.01% by weight or less.

When the polishing composition disclosed herein includes a basic compound, the concentration of the basic compound in the polishing liquid is not particularly limited. From the viewpoint of increasing the polishing removal rate, usually, the concentration is preferably 0.001% by weight or more of the polishing liquid, more preferably 0.003% by weight or more, and may be, for example, 0.005% by weight or more. From the viewpoint of haze reduction, the concentration is suitably less than 0.3% by weight of the polishing liquid, preferably less than 0.1% by weight, more preferably less than 0.05% by weight, and may be, for example less than 0.03% by weight.

When the polishing composition disclosed herein includes a surfactant, the amount thereof is not particularly limited as long as the effects of the present invention are not significantly impaired. Usually, from the viewpoint of cleanability, the amount of the surfactant with respect to 100 parts by weight of the abrasive is suitably 10 parts by weight or less, preferably 5 parts by weight or less, more preferably 1 part by weight or less, and may be 0.5 parts by weight or less, for example, 0.3 part by weight or less. From the viewpoint of exerting the effect of using the surfactant more satisfactorily, the amount of the surfactant with respect to 100 parts by weight of the abrasive grain is suitably 0.001 part by weight or more, preferably 0.005 parts by weight or more, and may be 0.01 parts by weight or more, or 0.03 parts by weight or more, for example, 0.05 parts by weight or more. The concentration of the surfactant in the polishing liquid may be, for example, 0.000001% by weight or more, 0.000005% by weight or more, 0.00001% by weight or more, 0.00005% by weight or more, 0.0001% by weight or more, or 0.0002% by weight or more. The concentration of the surfactant is usually suitably 0.2% by weight or less, and may be 0.1% by weight or less, 0.05% by weight or less, 0.01% by weight or less, 0.005% by weight or less, or 0.001% by weight or less.

### (Concentrate)

The polishing composition disclosed herein may be in a concentrated form before being supplied to the polishing object. The concentrated form is the form of a concentrate of a polishing liquid and can be grasped as a stock solution of a polishing liquid. The polishing composition in such a concentrated form is suitable from the viewpoints of convenience in manufacturing, distribution, storage, and cost reduction. The concentration ratio is not particularly limited, and can be, for example, about 2 times to 100 times in terms of volume, usually suitably about 5 times to 50 times, for example, about 10 times to 40 times.

Such a concentrated solution can be used in such a manner as to be diluted at a desired timing to prepare a polishing liquid (working slurry) and supply the polishing liquid to the polishing object. The dilution can be carried out, for example, by adding water to the concentrate and mixing.

The amount of the abrasive in the concentrate can be, for example, 50% by weight or less. From the viewpoint of handleability of the concentrate, for example, dispersion stability and filterability of the abrasive, usually, the amount of the abrasive in the concentrate is preferably 45% by weight or less, and more preferably 40% by weight or less. Also, from the viewpoint of convenience in manufacturing, distribution, storage and cost reduction, the amount of the abrasive can be, for example, 0.5% by weight or more, preferably 1% by weight or more, more preferably 3% by weight or more, for example, 4% by weight or more. **In** a preferred embodiment, the amount of the abrasive may be 5% by weight or more, 10% by weight or more, for example, 15% by weight or more, or 20% by weight or more, or 30% by weight or more.

### (Preparation of Polishing Composition)

The polishing composition used in the art disclosed herein may be in a one-agent type or a multi-agent type such as a two-agent type. For example, the polishing liquid can be prepared by mixing a part A including at least the abrasive among the constituent components of the polishing composition and a part B including at least a part of the remaining components, and these are mixed and diluted at an appropriate timing as needed.

A method for preparing the polishing composition is not particularly limited. For example, the components constituting the polishing composition may be mixed using a well-known mixing device such as a blade stirrer, an ultrasonic disperser, or a homomixer. The mode of mixing these components is not particularly limited, and for example, all the components may be mixed at once or may be mixed in a properly set order.

### <Polishing>

The polishing composition disclosed herein can be used for polishing a polishing object in a mode including, for example, the following operations. Hereinafter, a favorable embodiment of a method for polishing a polishing object, for example, a silicon wafer, by using the polishing composition disclosed herein will be described.

Thus, a polishing liquid including any of the polishing compositions disclosed herein is prepared. Preparing the polishing liquid may additionally include the operation of adjusting the concentration of the polishing composition, for example, by dilution, or adjusting the pH. Alternatively, the polishing composition may be used as it is as a polishing liquid.

Next, the polishing liquid is supplied to the polishing object and polishing is performed by a conventional method. For example, in the case of final polishing a silicon wafer, typically, the silicon wafer that has been subjected to lapping is set in a general polishing apparatus and a polishing liquid is supplied to the surface to be polished of the silicon wafer through a polishing pad of the polishing apparatus. Typically, the polishing pad is pressed against the surface to be polished of the silicon wafer and the two are moved, for example, rotated, relative to each other while continuously supplying the polishing liquid. Through this polishing step, the polishing of the polishing object is completed.

The polishing pad used in the polishing step is not particularly limited. For example, a polishing pad of a foamed polyurethane type, a nonwoven fabric type, or a suede type can be used. Each polishing pad may or may not include abrasive. Usually, a polishing pad not including abrasive is preferably used.

The polishing object polished using the polishing composition disclosed herein is typically cleaned. Cleaning can be carried out using an appropriate cleaning solution. The cleaning solution to be used is not particularly limited, and for example, an SC-1 cleaning solution, and an SC-2 cleaning solution generally used in the field of semiconductors can be used. The SC-1 cleaning solution is a mixed solution of ammonium hydroxide (NH₄OH), hydrogen peroxide (H₂O₂), and water (H₂O). The SC-2 cleaning solution is a mixed solution of HCl, H₂O₂, and H₂O. The temperature of the cleaning solution can be, for example, in a range from room temperature to about 90°C. The room temperature is typically about 15°C to 25°C. From the viewpoint of improving the cleaning effect, a cleaning solution at about 50°C to 85°C can be preferably used.

### <Stock polishing Composition>

The polishing composition disclosed herein can be favorably used in, for example, a polishing process including, for example, a final polishing step performed using the polishing composition and a stock polishing step performed prior to the final polishing step. Typically, the stock polishing step is performed by using a stock polishing composition having a composition different from that of the final polishing composition and supplying the stock polishing composition to the polishing object. The final polishing step is performed by supplying a final polishing composition including the polishing composition to the polishing object after polishing with the stock polishing composition. As the polishing composition used in the stock polishing step, a stock polishing composition including abrasive, a water-soluble polymer, and a basic compound can be preferably used.

Conventionally, in a polishing process including a stock polishing step and a final polishing step, the stock polishing step is positioned as a step of adjusting the shape of the polishing object and a rough surface state prior to the final polishing step. Therefore, in general, the surface roughness is efficiently reduced by removing the surface of the polishing object by using a stock polishing composition having a generally higher removal ability than the final polishing composition. Thus, in view of the importance of removal ability, generally, a water-soluble polymer has not been intentionally blended into the composition in the field of stock polishing compositions.

According to the art disclosed herein, by using a stock polishing composition including a water-soluble polymer in the stock polishing step, the smoothness of the surface of the polishing object at the start of final polishing can be further improved. As a result, even in the case of using a final polishing composition having a weaker removal ability and applying a small load to the surface of the polishing object in the final polishing step, the unevenness existing at the start of final polishing can be eliminated to a desired level, and the occurrence of new defects on the surface of the polishing object in the final polishing step can be suppressed.

In one embodiment, in the stock polishing composition, the weight ratio R1 of the water-soluble polymer to the abrasive of the stock polishing composition is preferably set smaller than the weight ratio R2 of the water-soluble polymer to the abrasive of the final polishing composition. As a result, it is possible to effectively improve the surface quality after the final polishing without excessively impairing the polishing removal rate in the stock polishing step.

### (Abrasive for Stock polishing)

The abrasive contained in the stock polishing composition, that is, the abrasive for stock polishing, can be appropriately selected, for example, from the abrasive exemplified above. The abrasive for stock polishing may be used singly or in combination of two or more types thereof. The abrasive for stock polishing and the abrasive for final polishing, that is, the abrasive contained in the final polishing composition, may be the same or may differ in at least one of material, size, and shape. The difference in size can be, for example, a difference in BET diameter.

As the abrasive for stock polishing, inorganic particles are preferable, and among them, particles composed of oxides of metals or metalloids are preferable, and silica particles are particularly preferable. The art disclosed herein can preferably be implemented in the form in which the abrasive for stock polishing are substantially composed of silica particles.

In one embodiment, the abrasive for stock polishing which have a BET diameter substantially equal to or larger than the BET diameter of the abrasive for final polishing can be preferably used. For example, the BET diameter of the abrasive for stock polishing may be about 0.9 times to 2.0 times, and may be about 1 time to 1.5 times the BET diameter of the abrasive for final polishing.

The concentration of the abrasive in the stock polishing composition, that is, the ratio of the weight of the abrasive to the weight of the polishing slurry is not particularly limited. In one embodiment, the concentration of the abrasive in the stock polishing composition may be, for example, 0.5 times to 20 times, 0.5 times to 10 times, and 0.5 times to 8 times the concentration of the abrasive in the final polishing composition.

### (Water-soluble Polymer for Stock polishing)

The water-soluble polymer contained in the stock polishing composition, that is, the water-soluble polymer for stock polishing can be appropriately selected, for example, from those exemplified hereinabove as the polymer A and the polymer B. The water-soluble polymer for stock polishing may be used singly or in combination of two or more types thereof. Any of the above-described polymer including an oxyalkylene unit, polymer including a nitrogen atom, polymer including a vinyl alcohol unit, cellulose derivative, and starch derivative, in which the adsorption parameter is 5 or more and less than 5 can be included in the list of water-soluble polymers for stock polishing that can be used in the art disclosed herein. Although not particularly limited, in one embodiment, for example, a cellulose derivative such as HEC can be preferably used as the water-soluble polymer for stock polishing.

The concentration of the water-soluble polymer for stock polishing is not particularly limited. In one embodiment, the concentration of the water-soluble polymer for stock polishing can be, for example, 0.00001% by weight or more, preferably 0.0001% by weight or more, and may be 0.0005% by weight or more, for example, 0.001% by weight or more. When the concentration of the water-soluble polymer for stock polishing increases, a higher quality surface tends to be obtained after final polishing. Meanwhile, from the viewpoint of polishing removal rate, the concentration of the water-soluble polymer for stock polishing is usually preferably 0.1% by weight or less, more preferably 0.05% by weight or less, and may be 0.01% by weight or less, for example, 0.005% by weight or less.

Further, the amount of the water-soluble polymer for stock polishing can be, for example, 0.0001 part by weight or more, usually suitably 0.005 parts by weight, and may be 0.01 parts by weight or more, 0.05 parts by weight or more, for example, 0.1 parts by weight or more per 100 parts by weight of the abrasive contained in the stock polishing composition. In addition, from the viewpoint of polishing removal rate, the amount of the water-soluble polymer for stock polishing is usually suitably 10 parts by weight or less, preferably 7 parts by weight or less, and may be 5 parts by weight or less, for example, 3 parts by weight or less per 100 parts by weight of the abrasive contained in the stock polishing composition.

In one embodiment, the weight ratio R1 of the water-soluble polymer to the abrasive in the stock polishing composition can be made smaller than the weight ratio R2 of the water-soluble polymer to the abrasive in the final polishing composition.

In this embodiment, the value of R1/R2 may be less than 1.0, for example 0.95 or less, and may be 0.9 or less. The art disclosed herein can also be favorably implemented in a mode in which R1/R2 is 0.7 or less, or in a mode in which R1/R2 is 0.5 or less. In addition, from the viewpoint of making the effect of including the water-soluble polymer in the stock polishing composition significantly easier to exhibit, R1/R2 is usually suitably 0.001 or more, for example, may be 0.005 or more, 0.01 or more, and 0.1 or more.

### (Basic Compound for Stock polishing)

The stock polishing composition typically includes a basic compound. The basic compound contained in the stock polishing composition, that is, the basic compound for stock polishing, is not particularly limited and may be appropriately selected, for example, from the basic compounds exemplified above. The basic compound for stock polishing may be used singly or in appropriate combination of two or more types thereof. The basic compound contained in the stock polishing composition may be the same compound as the basic compound contained in the final polishing composition or may be a different compound.

From the viewpoint of placing more importance on polishing removal rate in the stock polishing step, in one embodiment, at least one basic compound selected from an alkali metal hydroxide and a quaternary ammonium hydroxide can be preferably used as the basic compound for stock polishing. One favorable example of the quaternary ammonium hydroxide is a tetraalkylammonium hydroxide. Among them, an alkali metal hydroxide is preferable. One favorable example of the alkali metal hydroxide is potassium hydroxide. Further, from the viewpoint of placing more importance on surface quality after the final polishing, in one embodiment, ammonia can be preferably used as the basic compound for stock polishing.

The pH of the stock polishing composition is typically 8.0 or more, preferably 8.5 or more, more preferably 9.0 or more, even more preferably 9.5 or more, for example 10.0 or more. When the pH of the polishing composition is increased, the polishing removal rate tends to be improved. Meanwhile, from the viewpoint of preventing dissolution of the abrasive such as silica particles and suppressing a decrease in the mechanical polishing effect, the pH of the polishing composition is suitably 12.0 or less, preferably 11.8 or less, more preferably 11.5 or less, and still more preferably 11.0 or less. In one embodiment, the pH of the stock polishing composition can be set to be equal to or higher than the pH of the final polishing composition. For example, the pH of the stock polishing composition may be pH 12.0 or less and higher than the pH of the final polishing composition. This makes it possible to favorably achieve both high polishing removal rate in the stock polishing step and high surface quality in the final polishing step. The pH of the stock polishing composition may be higher than the pH of the final polishing composition by, for example, 0.1 or more, and may be higher by 0.2 or more.

### (Other Components)

The stock polishing composition may optionally include a surfactant. The surfactant can be appropriately selected from the surfactants exemplified above. In one embodiment, the stock polishing composition may be substantially free of surfactant.

In addition, the stock polishing composition may optionally further include a well-known additive that can be used in a polishing slurry, such as a chelating agent, an organic acid, an organic acid salt, an inorganic acid, an inorganic acid salt, an antiseptic agent, and an antifungal agent, as long as the effects of the present invention are not significantly impaired. For example, known additives that can be used in a polishing slurry which is to be used in polishing of silicon wafers can be used. Similarly to the final polishing composition, the stock polishing composition preferably does not substantially include an oxidizing agent.

### <Polishing Composition Set>

The matters provided by this specification are also inclusive of a polishing composition set including a final polishing composition including any of the polishing compositions described above and a stock polishing composition used in polishing performed before the polishing with the final polishing composition. The final polishing composition typically includes at least the polymer A as a water-soluble polymer. The stock polishing composition constituting the polishing composition set may be any one of the above-described polishing compositions. By using such a polishing composition set and performing polishing with the stock polishing composition prior to polishing with the final polishing composition, the defect reducing effect of using the final polishing composition including the polymer A can be exhibited more favorably. The weight ratio of the water-soluble polymer to the abrasive in the stock polishing composition can be set so as to be smaller than the weight ratio of the water-soluble polymer to the abrasive in the final polishing composition. This makes it possible to effectively improve the surface quality after the final polishing while suppressing the influence on the polishing efficiency in the stock polishing step.

### Examples

Several examples relating to the present invention will be described below, but the present invention is not intended to be limited to these examples. In the following description, "parts" and "%" are on a weight basis unless otherwise specified.

### <Measurement of Adsorption Parameter>

The adsorption parameter of each water-soluble polymer used in the following Examples and Comparative Examples was calculated in the following manner.

Test liquid L1 including 0.017% of a water-soluble polymer and 0.009% of ammonia, the remainder being water, was prepared. The total organic carbon amount (TOC) of this test liquid L1 was measured using a total organic carbon meter (combustion catalytic oxidation system, model "TOC-5000A") manufactured by Shimadzu Corporation, and converted into a volume to determine the total amount C1 of organic carbon contained in the test liquid L1.

Further, a test liquid L2 including 0.46% of silica particles, 0.017% of a water-soluble polymer, and 0.009% of ammonia, the remainder being water, was prepared. As silica particles, colloidal silica having a BET diameter of 35 nm was used. The test liquid L2 was subjected to centrifugal separation treatment for 30 min at 20,000 rpm using a centrifugal separator manufactured by Beckman Coulter Inc., type "Avanti HP-30I". The supernatant liquid after the above centrifugal separation treatment was recovered and the TOC of the supernatant liquid was measured with the total organic carbon meter. By converting the measurement result by the volume of the supernatant liquid, the total amount C2 of organic carbon contained in the supernatant was determined.

The adsorption parameter was calculated from C1 and C2 by the following formula:$Adsorption parameter = \left[\left(C1-C2\right)/C1\right] \times 100 .$

### <Stock polishing Step>

The contents of the stock polishing step used in the following Examples and Comparative Examples are as follows.

### (Stock polishing Step I)

A stock polishing composition I including 1.00% of abrasive and 0.068% of a basic compound, the remainder being water, was prepared. Colloidal silica having a BET diameter of 35 nm was used as the abrasive. Potassium hydroxide (KOH) was used as the basic compound.

A silicon wafer as a polishing object was polished under the following stock polishing conditions by using this stock polishing composition as it is as a polishing liquid (working slurry). A commercially available silicon single crystal wafer (conductive type: P type, crystal orientation: <100>, resistivity: 1 Ω·cm or more and less than 100 Ω·cm, COP free) with a diameter of 300 mm after lapping and etching was used as the silicon wafer.

### [Stock polishing Conditions]

Polishing apparatus: Single wafer polishing machine manufactured by Okamoto Machine
Tool Works, Ltd., model "PNX-332B"
Polishing pressure: 20 kPa
Platen revolution speed: 20 rpm
Carrier revolution speed: 20 rpm
Polishing pad: Fujibo Ehime Co., Ltd., product name "FP55"
Flow rate of polishing liquid: 1 L/min
Temperature of polishing liquid: 20°C
Temperature of platen cooling water: 20°C
Polishing time: 2 min

### (Stock polishing Step II)

A stock polishing composition II including 0.23% of abrasive, 0.003% of a water-soluble polymer and 0.014% of a basic compound, the remainder being water, was prepared. Hydroxyethyl cellulose (HEC) having an Mw of 120 × 10⁴ was used as the water-soluble polymer. Colloidal silica having a BET diameter of 35 nm was used as the abrasive. Ammonia was used as the basic compound.

A silicon wafer as a polishing object was polished under the stock polishing conditions in the same manner as in the stock polishing step I, except that the stock polishing composition II was used as it was as a polishing liquid.

### <Preparation of Polishing Composition and Final Polishing>

### (Example 1) (Reference)

A polishing composition including an abrasive, a water-soluble polymer and a basic compound at concentrations shown in Table 1, the remainder being water, was prepared. Colloidal silica having a BET diameter of 35 nm was used as the abrasive. A graft copolymer (hereinafter referred to as "PVA-g-PEO") having polyvinyl alcohol (PVA) with a saponification degree of 95% or more as a main chain and polyethylene oxide (PEO) as a side chain was used as the water-soluble polymer. In this example, PVA-g-PEO with Mw of 20000 was used.

This polishing composition was used as it was as a polishing liquid, and the silicon wafer after the stock polishing step I was polished under the following final polishing conditions.

### [Final Polishing Conditions]

Polishing apparatus: Single wafer polishing machine manufactured by Okamoto Machine
Tool Works, Ltd., model "PNX-332B"
Polishing pressure: 15 kPa
Platen revolution speed: 30 rpm
Carrier revolution speed: 30 rpm
Polishing pad: polishing pad manufactured by Fujibo Ehime Co., Ltd., product name "POLYPAS 27NX"
Flow rate of polishing liquid: 2 L/min
Temperature of polishing liquid: 20°C
Temperature of platen cooling water: 20°C
Polishing time: 2 min

The polished silicon wafer was removed from the polishing apparatus and cleaned (SC-1 cleaning) with a cleaning solution of NH₄OH (29%) : H₂O₂ (31%) : deionized water (DIW) = 1 : 3 : 30 (volume ratio). More specifically, two cleaning tanks equipped with an ultrasonic oscillator having a frequency of 950 kHz were prepared, the cleaning liquid was accommodated in each of the first and second cleaning tanks and held at 60°C, and the polished silicon wafer was immersed for 6 min in the first cleaning tank, then rinsed with ultrapure water under ultrasonic vibrations, immersed in the second cleaning tank for 6 min in the state where the ultrasonic oscillator was operated in each tank, pulled up in an isopropyl alcohol (IPA) atmosphere and dried.

### (Example 2) (Reference)

A polishing composition according to the present example was prepared in the same manner as in Example 1 except that colloidal silica having a BET diameter of 25 nm was used as the abrasive and the amount of the basic compound was changed as shown in Table 1. Final polishing, cleaning and drying of the silicon wafer after the stock polishing step I were carried out in the same manner as in Example 1 except that the prepared polishing composition was used.

### (Example 3)

A polishing composition according to the present example was prepared in the same manner as in Example 1 except that a surfactant having the concentration shown in Table 1 was further added. Polyoxyethylene decyl ether having the number of added moles of ethylene oxide of 5 (hereinafter referred to as "C10PEO5") was used as the surfactant. Final polishing, cleaning and drying of the silicon wafer after the stock polishing step I were carried out in the same manner as in Example 1 except that the prepared polishing composition was used.

### (Example 4) (Reference)

Final polishing, cleaning and drying of the silicon wafer after the stock polishing step II were carried out in the same manner as in Example 1.

### (Example 5)

A polishing composition according to the present example was prepared in the same manner as in Example 2 except that the concentration of the basic compound was changed as shown in Table 1, PVA-PVP as the water-soluble polymer was used at the concentration shown in Table 1, and a surfactant at the concentration shown in Table 1 was further included. The PVA-PVP is a random copolymer of vinyl alcohol and N-vinylpyrrolidone. The molar ratio of VA units : VP units contained in the PVA-PVP is 95 : 5. Ammonium polyoxyethylene lauryl ether sulfate (hereinafter referred to as "C12EO18SO3NH4") having a number of added moles of ethylene oxide of 18 was used as the surfactant. Final polishing, cleaning and drying of the silicon wafer after the stock polishing step I were carried out in the same manner as in Example 1 except that the prepared polishing composition was used.

### (Comparative Examples 1 and 2)

PVA-g-PEO used as a water-soluble polymer in the polishing composition of Example 1 was replaced with polyvinyl alcohol (saponification degree of 95% or more, hereinafter referred to as "PVA") or polyethylene oxide (hereinafter referred to as "PEO") having Mw and concentration shown in Table 1. Final polishing, cleaning and drying of the silicon wafer after the stock polishing step I were carried out in the same manner as in Example 1 except that the prepared polishing composition was used.

### (Comparative Example 3)

A simple mixture of PVA and PEO having Mw and concentration shown in Table 1 were simply mixed and used in place of PVA-g-PEO used as a water-soluble polymer in the polishing composition of Example 1. Final polishing, cleaning and drying of the silicon wafer after the stock polishing step I were carried out in the same manner as in Example 1 except that the prepared polishing composition was used.

### <Evaluation>

The silicon wafers obtained in the examples were evaluated in the following manner.

### (Measurement of Number of LPD-N)

The number of LPD-N present on the surface (polished surface) of the silicon wafer was measured using a wafer inspection apparatus "Surfscan SP2" (trade name) manufactured by KLA-Tencor Corporation, the measurement being carried out in the DCO mode of the same device. The measured number of LPD-N (number of LPD-N) is shown in Table 1 in the following three stages.
A: less than 50
B: 50 or more and 100 or less
C: more than 100

### (Haze Measurement)

The haze (ppm) was measured in the DWO mode by using a wafer inspection apparatus "Surfscan SP2" (trade name) manufactured by KLA-Tencor Corporation, and the results are shown in Table 1 in the following three stages.
A: less than 0.1 ppm
B: 0.1 ppm or more and 0.15 ppm or less
C: more than 0.15 ppm

### [Table 1]

**Table 1**

| | Abrasive grains | | | Basic compound | Water-soluble polymer | | | | Surfactant | | Pre-polishing | Evaluation | |
|---|---|---|---|---|---|---|---|---|---|---|---|---|---|
| | BET diameter [nm] | Concentration [wt%] | Type | Concentration [wt%] | Type | Mw | Concentration [wt%] | Adsorption parameter | Type | Concentration [wt%] | | Haze | LPD-N |
| Example 1 | 35 | 0.46 | NH₃ | 0.0097 | PVA-g-PEO | 20000 | 0.0075 | 65 | - | - | I | B | B |
| Example 2 | 25 | 0.17 | NH₃ | 0.0055 | PVA-g-PEO | 20000 | 0.0075 | 65 | - | - | I | A | A |
| Example 3 | 35 | 0.46 | NH₃ | 0.0097 | PVA-g-PEO | 20000 | 0.0075 | 65 | C10PEO5 | 0.0004 | I | A | A |
| Example 4 | 35 | 0.46 | NH₃ | 0.0097 | PVA-g-PEO | 20000 | 0.0075 | 65 | - | - | II | B | A |
| Example 5 | 25 | 0.17 | NH₃ | 0.022 | PVA-PVP | 12000 | 0.004 | 11 | C12EO18SO3NH4 | 0.0001 | I | B | A |
| Comparative Example 1 | 35 | 0.46 | NH₃ | 0.0097 | PVA | 100000 | 0.0075 | 0 | - | - | I | C | C |
| Comparative Example 2 | 35 | 0.46 | NH₃ | 0.0097 | PEO | 300000 | 0.0075 | 80 | - | - | I | C | C |
| Comparative Example 3 | 35 | 0.46 | NH₃ | 0.0097 | PVA | 100000 | 0.0075 | 0 | - | - | I | C | C |
| | | | | | PEO | 300000 | 0.0075 | 80 | | | | | |

Examples 3 and 5 are in accordance with the invention. Examples 1, 2 and 4 are reference examples.

As shown in Table 1, according to Examples 1 to 4 and Example 5 in which final polishing was performed using a polishing composition including a water-soluble polymer satisfying both of the conditions (1) and (2), the number of LPD-N and haze on the surface after final polishing were clearly reduced as compared with Comparative Examples 1 to 3 in which final polishing was performed using a polishing composition not containing a water-soluble polymer satisfying these conditions. From the results shown in the above table, it can be seen that the number of LPD-N and haze can be further improved by using the abrasive having a smaller BET diameter and blending a surfactant (Examples 2 and 3). It is also found that the number of LPD-N after final polishing can be further reduced (Example 4) by using a stock polishing composition including a water-soluble polymer in the stock polishing step.

Although specific examples of the present invention have been described in detail above, they are merely examples and do not limit the scope of the claims. The techniques described in the claims include those in which the specific examples exemplified above are variously modified and changed.

## Claims

1. **A polishing** composition comprising an abrasive, a water-soluble polymer, and a basic compound, wherein
the water-soluble polymer includes a polymer A,
the polymer A satisfies both of the following conditions:
(1) the polymer A includes a vinyl alcohol unit and a unit different from the vinyl alcohol unit in one molecule; and
(2) an adsorption parameter calculated by a following formula is 5 or more,$Adsorption parameter = \left[\left(C1-C2\right)/C1\right] \times 100 ,$
here, C1 in the above formula is a total amount of organic carbon contained in a test liquid L1 including 0.017% by weight of the polymer A and 0.009% by weight of ammonia, a remainder being water; and
C2 in the above formula is a total amount of organic carbon contained in a supernatant liquid obtained by centrifugally separating a test liquid L2 including 0.46% by weight of colloidal silica having a BET diameter of 35 nm, 0.017% by weight of the polymer A, and 0.009% by weight of ammonia, a remainder being water, and precipitating the abrasive,
wherein the polymer A is a random copolymer including a vinyl alcohol unit and an N-vinyl pyrrolidone unit in one molecule wherein the molar ratio of the vinyl alcohol units to the N-vinyl pyrrolidone units is 70:30 or greater or a copolymer including a vinyl alcohol unit and an oxyalkylene unit in one molecule,
wherein the polishing composition further comprises a surfactant having a weight-average molecular weight of less than 1 × 10⁴,
the amount of the surfactant is 0.001 parts by weight or more and 20 parts by weight or less per 100 parts by weight of the abrasive, and
the surfactant is a nonionic surfactant selected from the group consisting of block copolymers of ethylene oxide and propylene oxide, random copolymers of ethylene oxide and propylene oxide, and polyoxyethylene alkyl ethers, or an anionic surfactant comprising a polyoxyalkylene structure.

2. The polishing composition according to claim 1, wherein the polymer A is a copolymer including a vinyl alcohol-based segment and an oxyalkylene-based segment in one molecule.

3. The polishing composition according to claim 1, wherein the polymer A is a copolymer including a vinyl alcohol-based segment and an N-vinyl-based segment in one molecule.

4. The polishing composition according to claim 3, wherein the N-vinyl-based segment is a segment having a repeating unit derived from N-vinylpyrrolidone as a main repeating unit.

5. The polishing composition according to any one of claims 1 to 4, wherein the weight average molecular weight of the polymer A is 15 × 10⁴ or less.

6. The polishing composition according to any one of claims 1 to 5, wherein the abrasive has a BET diameter of 30 nm or less.

7. The polishing composition according to any one of claims 1 to 6, wherein an amount of the polymer A per 10¹⁷ abrasive grains is 10 mg to 1000 mg.

8. The polishing composition according to any one of claims 1 to 7, wherein the abrasive is silica particles.

9. Use of the polishing composition according to any one of claims 1 to 8 for polishing a silicon wafer.

10. A polishing composition set comprising:
a final polishing composition including the polishing composition according to any one of claims 1 to 10; and
a stock polishing composition including an abrasive, a water-soluble polymer and a basic compound and used for polishing performed before the polishing with the final polishing composition.

## Patentansprüche

1. Polierzusammensetzung, umfassend ein Schleifmittel, ein wasserlösliches Polymer und eine basische Verbindung, wobei
das wasserlösliche Polymer ein Polymer A einschließt,
das Polymer A beide der folgenden Bedingungen erfüllt:
(1) das Polymer A schließt eine Vinylalkoholeinheit und eine von der Vinylalkoholeinheit verschiedene Einheit in einem Molekül ein, und
(2) ein durch eine folgende Formel berechneter Adsorptionsparameter beträgt 5 oder mehr,$Adsorptionsparameter = \left[\left(C1-C2\right)/C1\right] \times 100 ,$
wobei hier C1 in der obigen Formel eine Gesamtmenge an organischem Kohlenstoff ist, die in einer Testflüssigkeit L1 enthalten ist, die 0,017 Gew.-% des Polymers A und 0,009 Gew.-% Ammoniak einschließt, wobei ein Rest Wasser ist, und
C2 in der obigen Formel eine Gesamtmenge an organischem Kohlenstoff ist, die in einer überstehenden Flüssigkeit enthalten ist, die durch zentrifugales Abtrennen einer Testflüssigkeit L2, die 0,46 Gew.-% kolloidales Siliciumdioxid mit einem BET-Durchmesser von 35 nm, 0,017 Gew.-% des Polymers A und 0,009 Gew.-% Ammoniak einschließt, wobei ein Rest Wasser ist, und Ausfällen des Schleifmittels erhalten wird,
wobei es sich bei dem Polymer A um ein statistisches Copolymer, das eine Vinylalkoholeinheit und eine N-Vinylpyrrolidoneinheit in einem Molekül einschließt, wobei das Molverhältnis der Vinylalkoholeinheiten zu den N-Vinylpyrrolidoneinheiten 70:30 oder größer ist, oder ein Copolymer, das eine Vinylalkoholeinheit und eine Oxyalkyleneinheit in einem Molekül einschließt, handelt,
wobei die Polierzusammensetzung ferner ein Tensid mit einem gewichtsmittleren Molekulargewicht von weniger als 1 × 10⁴ umfasst,
wobei die Menge des Tensids 0,001 Gewichtsteile oder mehr und 20 Gewichtsteile oder weniger pro 100 Gewichtsteile des Schleifmittels beträgt, und
wobei es sich bei dem Tensid um ein nichtionisches Tensid, ausgewählt aus der Gruppe bestehend aus Blockcopolymeren von Ethylenoxid und Propylenoxid, statistischen Copolymeren von Ethylenoxid und Propylenoxid und Polyoxyethylenalkylethern, oder ein anionisches Tensid, umfassend eine Polyoxyalkylenstruktur, handelt.

2. Polierzusammensetzung gemäß Anspruch 1, wobei es sich bei dem Polymer A um ein Copolymer handelt, das einen Abschnitt auf Vinylalkohol-Basis und einen Abschnitt auf Oxyalkylen-Basis in einem Molekül einschließt.

3. Polierzusammensetzung gemäß Anspruch 1, wobei es sich bei dem Polymer A um ein Copolymer handelt, das einen Abschnitt auf Vinylalkohol-Basis und einen Abschnitt auf N-Vinyl-Basis in einem Molekül einschließt.

4. Polierzusammensetzung gemäß Anspruch 3, wobei es sich bei dem Abschnitt auf N-Vinyl-Basis um einen Abschnitt handelt, der eine von N-Vinylpyrrolidon abgeleitete Wiederholungseinheit als Haupt-Wiederholungseinheit aufweist.

5. Polierzusammensetzung gemäß einem der Ansprüche 1 bis 4, wobei das gewichtsmittlere Molekulargewicht des Polymers A 15 × 10⁴ oder weniger beträgt.

6. Polierzusammensetzung gemäß einem der Ansprüche 1 bis 5, wobei das Schleifmittel einen BET-Durchmesser von 30 nm oder weniger aufweist.

7. Polierzusammensetzung gemäß einem der Ansprüche 1 bis 6, wobei eine Menge des Polymers A pro 10¹⁷ Schleifmittelkörner 10 mg bis 1000 mg beträgt.

8. Polierzusammensetzung gemäß einem der Ansprüche 1 bis 7, wobei es sich bei dem Schleifmittel um Siliciumdioxidpartikel handelt.

9. Verwendung der Polierzusammensetzung gemäß einem der Ansprüche 1 bis 8 zum Polieren eines Siliciumwafers.

10. Polierzusammensetzungssatz, umfassend:
eine Endpolierzusammensetzung, welche die Polierzusammensetzung gemäß einem der Ansprüche 1 bis 10 einschließt, und
eine Vorpolierzusammensetzung, die ein Schleifmittel, ein wasserlösliches Polymer und eine basische Verbindung einschließt und zum Polieren verwendet wird, das vor dem Polieren mit der Endpolierzusammensetzung durchgeführt wird.

## Revendications

1. Composition de polissage comprenant un abrasif, un polymère hydrosoluble et un composé basique, dans lequel
le polymère hydrosoluble comporte un polymère A,
le polymère A satisfait aux deux conditions suivantes :
(1) le polymère A comporte une unité alcool vinylique et une unité différente de l'unité alcool vinylique dans une seule molécule ; et
(2) un paramètre d'adsorption calculé par une formule suivante est de 5 ou plus,$paramètre d ' adsorption = \left[\left(C1-C2\right)/C1\right] \times 100 ,$
ici, C1 dans la formule ci-dessus est une quantité totale de carbone organique contenu dans un liquide d'essai L1, comportant 0,017 % en poids du polymère A et 0,009 % en poids d'ammoniac, le reste étant de l'eau ; et
C2 dans la formule ci-dessus est une quantité totale de carbone organique contenu dans un liquide surnageant obtenu par séparation centrifuge d'un liquide d'essai L2, comportant 0,46 % en poids de silice colloïdale ayant un diamètre BET de 35 nm, 0,017 % en poids du polymère A, et 0,009 % en poids d'ammoniac, le reste étant de l'eau, et par précipitation de l'abrasif,
dans laquelle le polymère A est un copolymère aléatoire comportant une unité alcool vinylique et une unité N-vinylpyrrolidone dans une molécule, dans laquelle le rapport molaire entre les unités alcool vinylique et les unités N-vinylpyrrolidone est de 70:30 ou plus, ou un copolymère comportant une unité alcool vinylique et une unité oxyalkylène dans une molécule,
dans laquelle la composition de polissage comprend en outre un tensioactif ayant un poids moléculaire moyen en poids inférieur à 1 x 10⁴,
la quantité du tensioactif est de 0,001 partie en poids ou plus et 20 parties en poids ou moins pour 100 parties en poids de l'abrasif, et
le tensioactif est un tensioactif non ionique sélectionné dans le groupe constitué de copolymères blocs d'oxyde d'éthylène et d'oxyde de propylène, de copolymères aléatoires d'oxyde d'éthylène et d'oxyde de propylène, et d'éthers d'alkyle de polyoxyéthylène, ou un tensioactif anionique comprenant une structure polyoxyalkylène.

2. Composition de polissage selon la revendication 1, dans laquelle le polymère A est un copolymère comportant un segment à base d'alcool vinylique et un segment à base d'oxyalkylène dans une molécule.

3. Composition de polissage selon la revendication 1, dans laquelle le polymère A est un copolymère comportant un segment à base d'alcool vinylique et un segment à base de N-vinyle dans une molécule.

4. Composition de polissage selon la revendication 3, dans laquelle le segment à base de N-vinyle est un segment ayant une unité de répétition dérivée de la N-vinylpyrrolidone comme unité principale de répétition.

5. Composition de polissage selon l'une quelconque des revendications 1 à 4, dans laquelle le poids moléculaire moyen en poids du polymère A est de 15 x 10⁴ ou moins.

6. Composition de polissage selon l'une quelconque des revendications 1 à 5, dans laquelle l'abrasif a un diamètre BET de 30 nm ou moins.

7. Composition de polissage selon l'une quelconque des revendications 1 à 6, dans laquelle une quantité du polymère A pour 10¹⁷ grains abrasifs est de 10 mg à 1 000 mg.

8. Composition de polissage est selon l'une quelconque des revendications 1 à 7, dans laquelle l'abrasif est constitué de particules de silice.

9. Utilisation de la composition de polissage selon l'une quelconque des revendications 1 à 8 pour polir une plaquette de silicium.

10. Ensemble de compositions de polissage comprenant :
une composition de polissage final comportant la composition de polissage selon l'une quelconque des revendications 1 à 10 ; et
une composition de polissage standard comportant un abrasif, un polymère hydrosoluble et un composé basique, et utilisée pour le polissage effectué avant le polissage avec la composition de polissage final.
